(19)

Europäisches
Patentamt
European
Patent Office
Office européen
des brevets

(11)  **EP 2 884 528 A1**

(12)  # EUROPEAN PATENT APPLICATION

(43) Date of publication:
**17.06.2015 Bulletin 2015/25**

(51) Int Cl.:
***H01L 21/67*** *(2006.01)*

(21) Application number: **14197625.8**

(22) Date of filing: **12.12.2014**

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**
Designated Extension States:
**BA ME**

(30) Priority: **12.12.2013 JP 2013257033**

(71) Applicant: **TOKYO ELECTRON LIMITED
Minato-ku
Tokyo 107-6325 (JP)**

(72) Inventors:
• **Funakoshi, Hideo
Hsin-chu City (TW)**
• **Kubota, Minoru
Kumamoto-ken (JP)**

(74) Representative: **Hoffmann Eitle
Patent- und Rechtsanwälte PartmbB
Arabellastraße 30
81925 München (DE)**

(54)  **Liquid supplying apparatus**

(57)     An embodiment of a liquid supplying apparatus for supplying a processing liquid to a process object includes: a processing liquid cartridge including: a reservoir chamber for storing the processing liquid; an ejecting port for ejecting the processing liquid stored in the reservoir chamber; a pusher unit for pushing the processing liquid stored in the reservoir chamber outward through the ejecting port; and a replenishing port for replenishing the processing liquid into the reservoir chamber; a standby unit having a standby area where the processing liquid cartridge is standing-by; a transport mechanism that transports the processing liquid cartridge between the standby unit and a location where the processing liquid cartridge supplies the processing liquid to the process object; and an actuating mechanism provided in the transport mechanism that drives the pusher unit to push the processing liquid stored in the reservoir chamber.

FIG. 1

**Description**

FIELD OF THE INVENTION

The present invention relates to a liquid supplying apparatus for supplying a processing liquid to a process object.

BACKGROUND ART

A series of steps for manufacturing semiconductor devices include a step of supplying a processing liquid, such as a thinner, a resist liquid, a polyimide or an adhesive, to a semiconductor wafer (hereinafter simply referred to as "wafer") as a substrate (process object). Higher viscosity of the processing liquid makes it more difficult to eject the processing liquid. As the wafer diameter increases, the amount of the processing liquid required for coating the whole surface of the wafer increases. In order to suppress the throughput reduction, the processing liquid is required to be ejected in a short time.

However, if a pump having a larger capacity is employed to increase the processing liquid-ejecting rate, the processing apparatus including such a pump becomes more expensive. If processing liquid-feeding pipes having a larger internal diameter are employed to increase the processing liquid-ejecting rate, routing of the pipe becomes difficult and the layout of the apparatus and the workability of the operators are restricted.

After a pump discharges the processing liquid to the nozzle, a new processing liquid is drawn into the pump from a processing liquid container for the next discharging. It is impossible to set the charging rate, at which the processing liquid is drawn into the pump, to be so high, because a high charging rate results in generation of bubbles in the processing liquid. Under the circumstances, the preparation of the processing liquid ejection is required to be performed within as short a time as possible. As the viscosity of the processing liquid becomes higher, the pressure loss upon drawing of the processing liquid becomes greater so that generation of bubbles in the processing liquid is more likely to occur. Thus, particularly in a process using a highly viscous processing liquid, the preparation of the processing liquid ejection is required to be performed as rapidly as possible.

Japanese Patent No.JP4227171B2 describes a method of coating a wafer with a resist liquid by using a plurality of syringes. In this method, an arm picks up one of the syringes placed on a tray, the resist liquid is ejected from the one syringe held by the arm, and the one syringe is returned to the tray.

JP2004-172201A describes a coating method in which a container storing a chemical liquid is held by a holding mechanism, and is moved to a position above a wafer, and the chemical liquid is ejected from the container directly to the wafer. Neither Citation 1 nor 2 considers problems associated with a highly viscous processing liquid to be ejected.

SUMMARY OF THE INVENTION

The object of the present invention is to provide a liquid supplying apparatus that can shorten the time required for ejecting a processing liquid toward a process object, without complicating the structure of the apparatus.

The liquid processing apparatus of the present invention is a liquid supplying apparatus for supplying a processing liquid to a process object, which includes: a processing liquid cartridge including: a reservoir chamber for storing the processing liquid; an ejecting port for ejecting the processing liquid stored in the reservoir chamber; a pusher unit for pushing the processing liquid stored in the reservoir chamber outward through the ejecting port; and a replenishing port for replenishing the processing liquid into the reservoir chamber; a standby unit having a standby area where the processing liquid cartridge is standing-by; a transport mechanism that transports the processing liquid cartridge between the standby unit and a location where the processing liquid cartridge supplies the processing liquid to the process object; and an actuating mechanism provided in the transport mechanism that drives the pusher unit to push the processing liquid stored in the reservoir chamber.

The standby unit may have a processing liquid replenishing passage for replenishing the processing liquid to the processing liquid cartridge, and the liquid supplying apparatus may further comprises a replenishing mechanism that replenishes the processing liquid to the reservoir chamber of the processing liquid cartridge through the replenishing port. In this case, the replenishing mechanism is provided in the standby unit. The pusher unit may include a bellows body having a proximal opened end portion, and the reservoir chamber has an opened end portion to which the proximal opened end portion of bellows body is joined; and the actuating mechanism may be configured to expand the bellows body to reduce a volume of the reservoir chamber, thereby to eject the processing liquid from the ejecting port.

The liquid supplying apparatus may further comprises a replenishing mechanism that replenishes the processing liquid to the reservoir chamber of the processing liquid cartridge located in the standby unit through the replenishing port, wherein the replenishing mechanism is configured to compress the bellows body to increase the volume of the reservoir chamber, thereby to suction the processing liquid through the replenishing port. The pusher unit may have a driving rod having a distal end connected to a distal end of the bellows body and a proximal end extending outward from the reservoir chamber; and the actuating mechanism may include a forward driving unit that drives the driving rod forward to expand the bellows body.

The liquid supplying apparatus may further comprise a replenishing mechanism that replenishes the processing liquid to the reservoir chamber of the processing liquid cartridge located in the standby unit through the replenishing port, wherein the pusher unit may have a driving rod having a distal end connected to a distal end of the bellows body and a proximal end extend outward from the reservoir chamber, and the actuating mechanism may include a backward driving unit that drives the driving rod backward to compress the bellows body. The actuating mechanism may include a gas supply unit that supplies a gas into an interior of the bellows body through the opened end portion of the bellows body, thereby to expand the bellows body. The liquid supplying apparatus may further comprise a replenishing mechanism that replenishes the processing liquid to the reservoir chamber of the processing liquid cartridge located in the standby unit through the replenishing port, wherein the replenishing mechanism includes a suction mechanism that suctions the processing liquid in the bellows body through the opened end portion of the bellows body, thereby to compress the bellows body.

The processing liquid cartridge may have a memory in which a type of the processing liquid stored in the processing liquid cartridge is stored. In this case, it is preferable that the standby unit has a plurality of standby areas, and a reading unit that reads the type of the processing liquid stored in the processing liquid cartridge stored in the memory, and that the liquid supplying apparatus further comprises a control unit configured to output a control signal instructing to select one from a plurality of processing liquid cartridges suitable for a coating process to be performed to a process object, based on data read out by the reading unit.

The processing liquid cartridge may have a locking mechanism that locks the pusher unit at a position remote from the ejecting port; and the transport mechanism may be provided with a release mechanism that releases locking of the pusher unit by the locking mechanism. The processing liquid cartridge may include a first back-flow prevention mechanism for preventing a backflow of the processing liquid into the reservoir chamber through the ejecting port, and a second back-flow prevention mechanism for preventing a backflow of the processing liquid from the reservoir chamber through the replenishing port; and a drip prevention mechanism may be provided between the first back-flow prevention mechanism and the ejecting port to suction the processing liquid existing near the ejecting port upward toward the reservoir chamber, after ejection of the processing liquid. A viscosity of the processing liquid may be within a range of 1000cP to 4000cP.

In the present invention for supplying a processing liquid to a process object, the reservoir chamber of storing the processing liquid and the ejecting port for ejecting the processing liquid are integrated with each other as the processing liquid cartridge. The processing liquid cartridge is transported toward the process object from the standby unit where the processing liquid cartridge is standing-by, and the processing liquid is ejected from the processing liquid cartridge to the process object. Thus, the ejecting port and the pusher unit for pushing the processing liquid stored in the reservoir chamber can be close to each other. As a result, as compared with a structure in which the ejecting port is located on one end of a long pipe and the processing liquid is pushed out by a pump located on the other end of the pipe, a length along which the processing liquid flows can be reduced. Therefore, since there is a less pressure loss, the processing liquid can be promptly ejected, without complicating the apparatus. In addition, since the replenishing port for replenishing the processing liquid into the reservoir chamber of the processing liquid cartridge is provided separately from the ejecting port, the ejecting port can be prevented from being contaminated when the processing liquid is replenished to the reservoir chamber.

BRIEF DESCRIPTION OF THE DRAWINGS

Fig. 1 is a perspective view of a resist coating apparatus including a liquid supplying apparatus in one embodiment of the present invention.
Fig. 2 is a plan view of the liquid processing apparatus.
Fig. 3 is a perspective view of a cartridge provided in the liquid processing apparatus.
Fig. 4 is a longitudinal sectional view of the cartridge.
Fig. 5 is a longitudinal sectional view for explaining the operation of the cartridge.
Fig. 6 is a longitudinal sectional view for explaining the operation of the cartridge.
Fig. 7 is a longitudinal sectional view for explaining the operation of the cartridge.
Fig. 8 is a longitudinal sectional view for explaining the structure of a replenishing mechanism for replenishing a processing liquid to the cartridge.
Fig. 9 is a perspective view of the replenishing mechanism and the cartridge.
Fig. 10 is a longitudinal sectional view for explaining the operation of the replenishing mechanism.
Fig. 11 is a perspective view showing a mechanism for holding the cartridge.
Fig. 12 is a side view showing the holding mechanism and a mechanism for ejecting a resist liquid in the cartridge.
Fig. 13 is a perspective view showing a part of the ejecting mechanism.
Fig. 14 is a diagram showing the configuration of a control unit provided in the liquid supplying apparatus.
Fig. 15 is a side view showing the operation of the liquid supplying apparatus.
Fig. 16 is a side view showing the operation of the liquid supplying apparatus.
Fig. 17 is a side view showing the operation of the liquid supplying apparatus.
Fig. 18 is a side view showing the operation of the liquid supplying apparatus.

Fig. 19 is a longitudinal sectional view of another embodiment of the liquid supplying apparatus showing the operation for ejecting the processing liquid.

Fig. 20 is a longitudinal sectional view of said another embodiment showing the operation for replenishing the processing liquid.

Fig. 21 is an enlarged longitudinal sectional view of said another embodiment showing the details of the connection of the cartridge to an ejection or a replenishing mechanism.

Fig. 22 is a perspective view showing yet another embodiment of the liquid supplying apparatus.

Fig. 23 is a flowchart for explaining the sequence of operations of the liquid supplying apparatus in said yet another embodiment.

Fig. 24 is a longitudinal sectional view showing still yet another embodiment of the liquid supplying apparatus.

Figs. 25 to 33 are graphs showing the results of the experiments.

## EMBODIMENTS FOR CARRYING OUT THE INVENTION

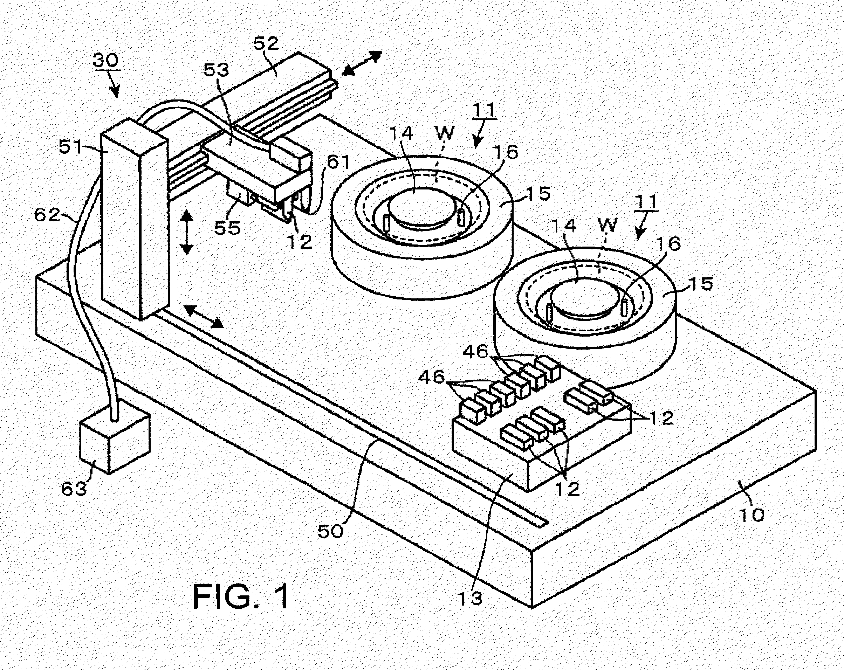

A liquid supplying apparatus in one embodiment of the present invention, and a resist coating apparatus into which the liquid supplying apparatus is incorporated, will be explained below with reference to Figs. 1 to 14. The resist coating apparatus includes: a processing unit 11 on which a wafer W, which is a substrate as a process object, is placed to apply thereto a processing liquid (resist liquid); and a standby unit 13 on which cartridges 12, each of which is a processing liquid cartridge storing the resist liquid, are placed. As described below, a transport mechanism 30, which is horizontally movable, is disposed between the processing unit 11 and the standby unit 13. The cartridge 12 is transported by the transport mechanism 30 from the standby unit 13 to a position right above the wafer W where the cartridge 12 ejects the resist liquid to the wafer W. In this embodiment, two processing units 11 are arranged side by side, and there are a plurality of (six, in the illustrated embodiment) cartridges 12.

As shown in Fig. 1, each processing unit 11 is equipped with a spin chuck 14 that holds the back surface of the wafer W by suctioning. The spin chuck 14 is rotatable about a vertical axis by a rotating mechanism, not shown. In Fig. 1, the reference numeral 15 depicts a cup body, and the reference numeral 16 depicts lift pins for moving the wafer W upward and downward. In Fig. 1, the reference number 10 depicts a base part on which the respective processing units 11 are mounted.

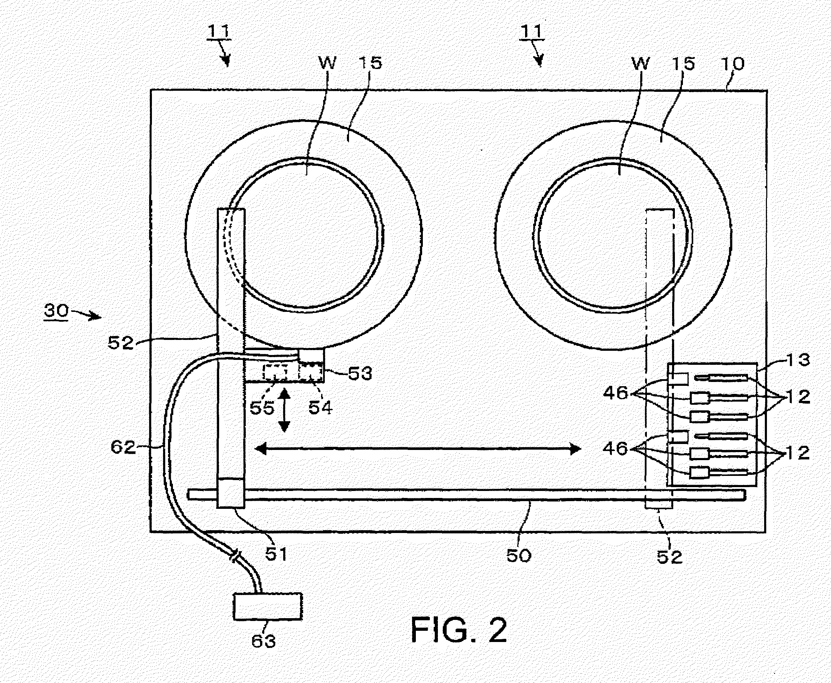

As shown in Figs. 1 and 2, the standby unit 13 has a substantially box-like shape. The six cartridges 12 are placed on the standby unit 13 and arrayed in a direction perpendicular to the direction along which the processing units 11 are arranged side by side. The standby unit 13 includes a mechanism for replenishing a resist liquid to each cartridge 12, and a member for reading data indicating the type of the resist liquid stored in each cartridge 12. The mechanism and the member will be explained later. In Fig. 1, the transport mechanism 30 is now holding one cartridge 12, while five cartridges 12 are placed on the standby unit 13.

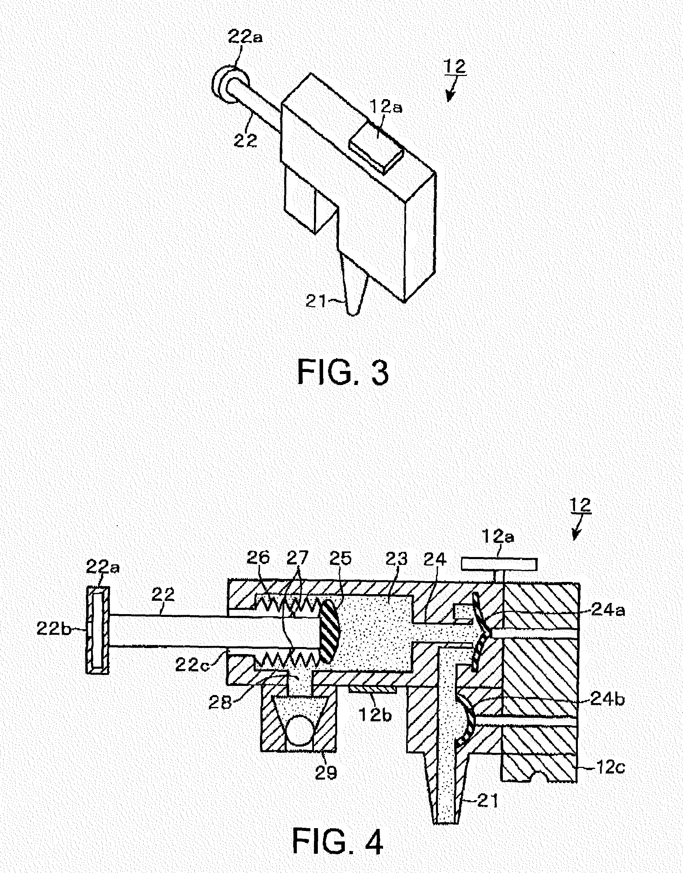

Next, the cartridge 12 placed on the standby unit 13 is described in detail. As shown in Fig. 3, the cartridge 12 has a thin planar shape. In a plan view, the cartridge 12 is elongated in the traveling direction of the aforementioned transport mechanism 30. A planar tab 12a, which is to be held by the transport mechanism 30, is disposed on an upper surface of the cartridge 12. The tab 12a is fixed on the cartridge 12 at a position slightly remote from the upper surface of the cartridge 12. The lower surface of the tab 12a (the part to be held by an arm unit 53 described below) has a not-shown projection for positioning the cartridge 12.

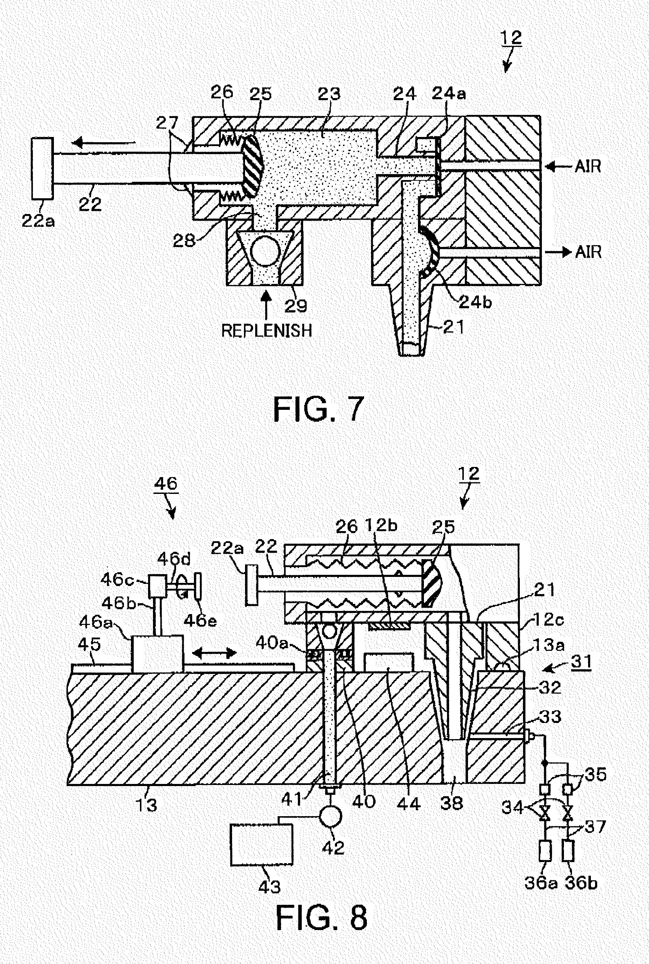

A nozzle 21 and a positioning member 12c are disposed on a lower surface of the cartridge 12 on one end portion thereof with respect to the longitudinal direction thereof. The nozzle 21 has an ejecting port (a discharging port) for ejecting the resist liquid. The positioning member 12c is provided to locate the cartridge 12 in place. In detail, as also shown in Fig. 8, a projection 13a is provided on an upper surface of the standby unit 13, while the lower surface of the positioning member 12c has a recess to be engaged with the projection 13a. As shown in Fig. 4, an IC chip 12b, which serves as a memory in which the type of the resist liquid stored in the cartridge 12 is stored, is applied onto a central portion of the lower surface of the cartridge 12. The IC chip 12b also stores data indicating that the cartridge 12 is a genuine product.

A shaft 22 extends in the longitudinal direction of the cartridge 12 from a side surface on the other end portion of the cartridge 12. The shaft 22 serves as a pusher unit (driving rod) that pushes the resist liquid out of the cartridge 12 toward the nozzle 21. As shown in Fig. 4, a reservoir chamber 23 for storing the resist liquid is formed in the cartridge 12, and a liquid passage 24 is formed between the reservoir chamber 23 and the nozzle 21 so as to communicate the reservoir chamber 23 and a flow path (ejection path) inside the nozzle 21 with each other.

An inner wall surface of the reservoir chamber 23 on the side of the shaft 22 is referred to as a wall surface part 25. The wall surface part 25 can be separated from the top surface, the bottom surface and the other side surfaces of the reservoir chamber 23. The wall surface part 25 is connected to the distal end of the shaft 22 so as to be moved forward and backward by the shaft 22. A bellows body 26 extends in the longitudinal direction of the shaft 22 to surround the outer circumferential surface of the shaft 22. The bellows body 26 is sealingly connected to the rear surface (i.e., the surface to which the shaft 22 is connected) of the wall surface part 25 and the inner wall surface of the reservoir chamber 23 surrounding an opening 22c serving as a shaft insertion hole. In other words, the portion of the reservoir chamber 23 around the opening 22c and the open end portion of the bellows body 26 are joined to each other. Thus, when the shaft 22 is moved forward toward the nozzle 21, the volume surrounded by the bellows body 26 increases in the reservoir chamber 23, so that the resist liquid in the reservoir chamber 23 is pushed out toward the nozzle 21.

A plurality of (e.g., two) latches 27, serving as a locking mechanism, are provided on the outer circumferential surface of the shaft 22 near the distal end thereof. The latches 27 can retract and project into and from the outer circumferential surface of the shaft 22. The latches 27 are arranged so as not to interfere with the bellows body 26 in the reservoir chamber 23. In addition, the latches 27 are arranged such that, when the latches 27 go out from the reservoir chamber 23 according to the backward movement of the shaft 22, the latches 27 are engaged with the periphery of the opening 22c (the wall of reservoir chamber 23 around the opening 22) so as to lock the position of the wall surface part 25.

A disc-shaped, hollow engagement member 22a is disposed on the distal end of the shaft 22. An elongated hole 22b is formed in a side wall, remote from the shaft 22, of the engagement member 22a. The hole 22b is configured to be engaged with a below-described replenishing mechanism 46 (an engagement part 46e, in detail). The structure for moving the shaft 22 forward and backward will be described later, together with the replenishing mechanism 46.

A replenishing port 28 for replenishing the resist liquid into the reservoir chamber 23 is formed in the bottom wall of the reservoir chamber 23. A check valve 29, which serves as a back-flow prevention mechanism for preventing backflow of the resist liquid, is disposed in a passage extending from the replenishing port 28. The check valve 29 allows inflow of the resist liquid from the replenishing port 28 into the reservoir chamber 23, but prevents backflow (outflow) of the resist liquid from the reservoir chamber 23 toward the replenishing port 28.

The liquid passage 24 is provided with a shutoff valve 24a for opening and closing the liquid passage 24 serving as the back-flow prevention mechanism, and a suck-back valve 24b serving as a drip prevention mechanism to draw the liquid upward from the tip end portion of the nozzle 21, which are arranged in this order from the reservoir chamber 23 to the nozzle 21. The shutoff valve 24a and the suck-back valve 24b are each configured as a diaphragm valve that operates upon supplying (or evacuating) a space behind the valve element. When a gas is supplied to the space behind the shutoff valve (valve element) 24a, the shutoff valve 24a closes the liquid passage 24. On the other hand, when the space behind the shutoff valve 24a is suctioned so that a negative pressure prevails therein, the shutoff valve 24a allows the resist liquid to flow through the liquid passage 24.

When a gas is supplied to the space behind the suck-back valve 24b, the suck-back valve 24b is positioned along the inner surface of the liquid passage 24. On the other hand, when the space behind the suck-back valve 24b is suctioned, the suck-back valve 24b is retracted from the liquid passage 24 so that the resist liquid in the liquid passage 24 is drawn into the suck-back valve 24b. Gas passages through which a gas is supplied to or discharged from the shutoff valve 24a and the suck-back valve 24b are disposed in or on the arm unit 53. These gas passages of the arm unit 53 are connected to or disconnected from the corresponding gas passage of the cartridge 12, upon attachment or detachment of the cartridge 12 to and from the arm unit 53. The detailed explanation of the connection of the gas passages are omitted herein.

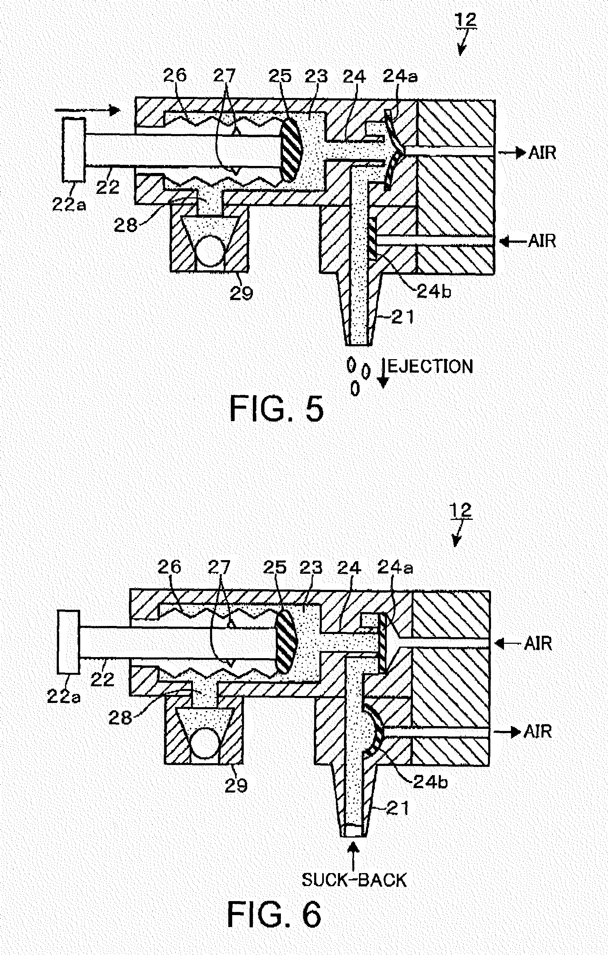

As shown in Fig. 5, in the above-described cartridge 12, when the shutoff 24a is opened and the shaft 22 is moved forward toward the nozzle 21, the resist liquid is ejected from the nozzle 21. The amount of the resist liquid to be ejected (the ejection amount of the resist liquid) depends on (and thus can be set based on) the forward movement distance of the shaft 22 (or the position of the shaft 22). In detail, when the shaft 22 moves forward, the volume of the space surrounded by the bellows body 26 increases in the reservoir chamber 23, as described above. Thus, if the relationship between the volume of the space and the position of the shaft 22 is obtained through experiment in advance, the ejection amount of the resist liquid can be set based on the position of the shaft 22.

As shown in Fig. 6, after completion of the resist-liquid ejecting process, the resist liquid is suctioned upward from the tip end portion of the nozzle 21 by retracting the suck-back valve 24b from the liquid passage 24b.

On the other hand, as shown in Fig. 7, when the shutoff valve 24a is closed and the shaft 22 is moved backward, the check valve 29 is opened so that the resist liquid is replenished or flown into the reservoir chamber 23 through a processing liquid replenishing passage 41 in the standby unit 13 and the replenishing port 28. When the shaft 22 is further moved backward so that the latches 27 are located outside the reservoir chamber 23, the latches 27 are engaged with the periphery of the opening 22c of the cartridge 12, whereby the position of the shaft 22 is fixed with the reservoir chamber 23 being (fully) filled with the resist liquid. In Figs. 5 to 7, some parts of the cartridge 12 are omitted for simplicity of the drawings.

The aforementioned standby unit 13 is configured to replenish the resist liquid into the cartridge 12, configured to read the data stored in the IC chip 12b, and configured to clean the nozzle 21. In detail, the standby unit 13 has six standby areas 31 for the cartridges 12, which are arranged side by side on the upper surface of the standby unit 13. As shown in Fig. 8, each standby area 31 is provided with a recess 32, which is to be located below the nozzle 21. Fig. 8 is a partially-broken sectional view illustrating the cartridge 12, in which some parts of the cartridge 12 are omitted for simplicity of the drawing.

The recess 32 has an inner diameter slightly larger than the external diameter of the nozzle 21. A supply passage 33, for supplying a cleaning liquid and a drying-preventing gas to the tip end portion of the nozzle 21, opens into the recess 32 in the inner wall surface of the recess 32. In Fig. 8, the reference numeral 34 depicts valves, and the reference numeral 35 depicts flow rate regulating units. In the illustrated embodiment, in order that a liquid thinner can be supplied as the cleaning liquid and a gaseous thinner can be supplied as the drying-preventing gas, the valves 34 and the flow rate regulating units 35 are provided in supply passages 37 extending form supply sources 36a and 36b. The lower part of the recess 32 extends downward in a cylindrical form to serve as a draining passage 38.

The projection 13a to be engaged with the positioning member 12c of the cartridge 12 is formed beside the recess 32. Thus, when the positioning member 12c and the projection 13a are engaged with each other, the cartridge 12 is fixedly positioned in the standby area 31. Thus, even when the shaft 22 is moved forward or backward, the cartridge 12 will not displace. Although plural projections 13 are formed at plural locations, illustration thereof is omitted.

The part of the standby area 31 corresponding to the check valve 29 protrudes upward to define a protrusion 40 facing the check valve 29. The processing liquid replenishing passage 41 for replenishing the resist liquid to the cartridge 12 has an open end that opens in the upper surface of the protrusion 40. The open end of the processing liquid replenishing passage 41 is positioned so as to be overlapped with the replenishing port 28, in a plan view. A sealing member 40a such as an O-ring is embedded in the protrusion 40 to surround the open end of the processing liquid replenishing passage 41. When the resist liquid is replenished or supplied to the cartridge 12, the processing liquid replenishing passage 41 and the cartridge 12 (or the check valve 29) are hermetically connected to each other via the sealing member 40a. The other end of the processing liquid replenishing passage 41 is connected, at a position below the standby unit 13, to a reservoir 43 storing the resist liquid through a feed pump 42. The feed pump 42 is configured such that the feed pump 42 does not interfere with the resist liquid passage in the feed pump 42 when the resist liquid is replenished into the cartridge 12, so that the resist liquid can freely flow through the passage. The feed pump 42 is also configured such that the feed pump 42 maintains the level (height position) of the resist liquid in the processing liquid replenishing passage 41 at the level of the upper surface of the protrusion 40 when the replenishment of the resist liquid is completed. Namely, the feed pump 42 is provided to prevent the lowering of the liquid level of the resist liquid, in order to prevent (or reduce as much as possible) bubbles from entering the cartridge 12 through the processing liquid replenishing passage 41. Alternatively, a check valve may be provided in place of the above feed pump 42 in order to prevent backflow (lowering) of the resist liquid in the processing liquid replenishing passage 41.

In addition, the standby area 31 has a reading unit 44 that reads the data stored in the IC chip 12b of the cartridge 12. The reading of the data may be performed in non-contact manner. The data read by the reading unit 44 are transmitted to a below-described control unit 71 through a not-shown signal line, which passes through the inside of the standby unit 13, for example.

The replenishing mechanism 46 is disposed beside the standby area 31 so as to face the shaft 22 of the cartridge 12 placed on the standby area 31. The replenishing mechanism 46 is configured to be movable forward and backward on a rail 45, which runs along the direction in which the shaft 22 extends. To be specific, the replenishing mechanism 46 includes a base 46a that travels along the rail 45, a support column 46b extending vertically upward from the base 46a, and a rotating mechanism 46c supported by the support column 46b. A rotating shaft (driving unit) 46d extends horizontally toward the shaft 22, from one side of the rotating mechanism 46c facing the shaft 22. The rotating shaft 46d is rotatable about a horizontal axis located at the same level (height position) as that of the shaft 22 of the cartridge 12 placed on the standby area 31.

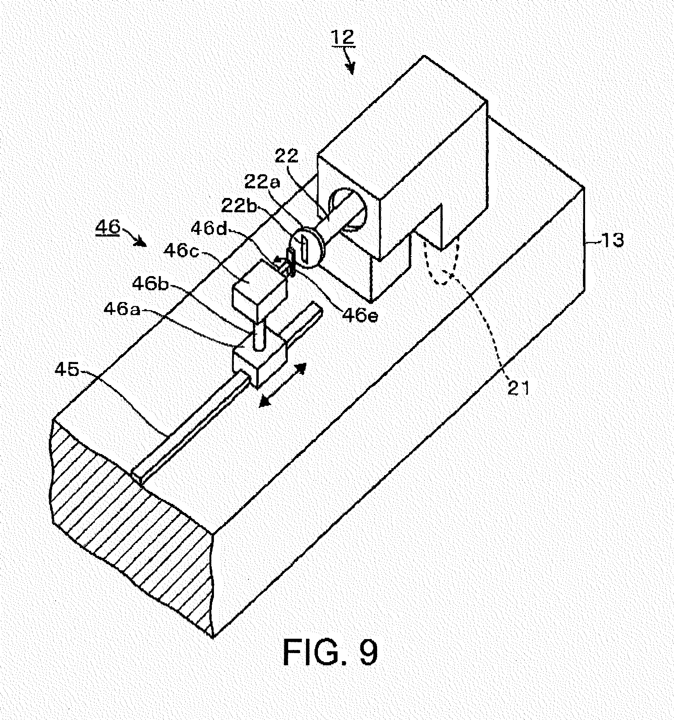

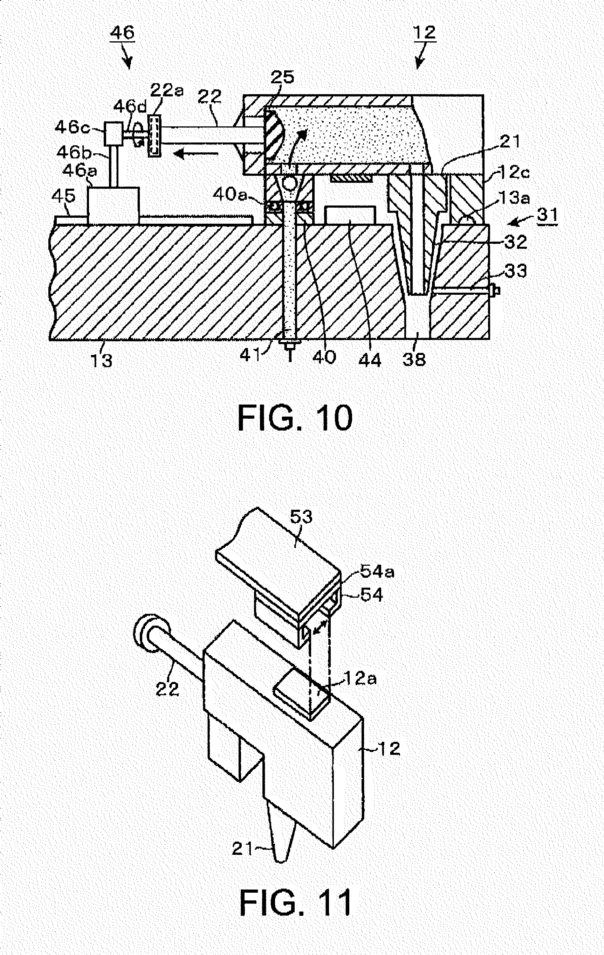

As show in Fig. 9, a bar-shaped engagement part 46e extending perpendicularly to the longitudinal direction of the rotating shaft 46d is provided on the distal end (the end near the cartridge 12) of the rotating shaft 46d. The center (with respect to the longitudinal direction of the engagement part 46e) of the engagement part 46e is supported by the rotating mechanism 46c. The engagement part 46e has a length slightly smaller than that of the hole 22b of the engagement member 22a of the shaft 22. Thus, when the engagement part 46e (replenishing mechanism 46) is moved forward to the shaft 22 such that the engagement part 46e is received in the hole 22b, and then the engagement part 46e is rotated at an angle (e.g., 90°) about the horizontal axis, the engagement part 46e and the engagement member 22a are engaged with each other. As shown in Fig. 10, by moving the replenishing mechanism 46 forward or backward, the shaft 22 is moved forward or backward together with the replenishing mechanism 46. Fig. 10 illustrates that the shaft 22 is fully drawn out from the reservoir chamber 23 of the cartridge 12, and thus the cartridge 12 is (fully) filled with the resist liquid.

A not-shown liquid reservoir storing a solvent is disposed in the vicinity of the standby unit 13. Since the solvent stored in the liquid reservoir volatilizes, a solvent atmosphere is formed in a space where the cartridge 12 is placed. Due to the solvent atmosphere, drying of the nozzle 21 of the cartridge 12 (in more detail, drying of the resist liquid inside the tip end portion of the nozzle 21) placed on the standby unit 13 is suppressed.

Next, the explanation is made for the transport mechanism 30 that transports the cartridge 12 between the processing unit 11 and the standby unit 13. As shown in Figs. 1 and 2, a rail 50 is formed in the base part 10 to extend along the direction in which the processing units 11 are arranged side by side. The rail 50 extends along one end of the base part 10 from a position corresponding to the processing units 11 to a position corresponding to the standby unit 13. As shown in Figs. 1 and 2, the transport mechanism 30 includes a vertically-extending pole 51 that travels along the rail 50, and a beam 52 engaging with a not-shown guide formed in the pole 51 to extend along the longitudinal direction thereof so as to move upward and downward. The beam 52 horizontally extends perpendicularly to the longitudinal direction of the rail 50 so as to cover a region from a position corresponding to the standby area 31 nearest to the rail 50 to a position corresponding to the center of the wafer W placed on the processing unit 11. The arm 53 is mounted to a side surface of the beam 52 so as to be movable along the longitudinal direction of the beam 52.

As shown in Fig. 11, a holder 54 is provided at the distal end thereof on a lower surface of the arm unit 53 to hold the cartridge 12 from both sides (from the right side and the left side of the cartridge 12, or the longitudinal direction of the beam 52). The holder 54 is disposed on a lower surface of a planar member 54a in which a holding mechanism comprising a motor is accommodated. The holder 54 is configured to be movable in the right and left direction between a position at which the tab 12a of the cartridge 12 is held from below by the holding mechanism, and a position separated from the tab 12a. The holder 54 has a recess formed in a part thereof (i.e., an upper surface of a horizontal part) to be in contact with the tab 12a. The recess is configured to be engaged with a not-shown projection of the tab 12a. Thus, when the cartridge 12 is held by the holder 54, the position of the cartridge 12 with respect to the arm unit 53 is fixed. Illustration of the aforementioned holding mechanism accommodated in the planar member 54a is omitted.

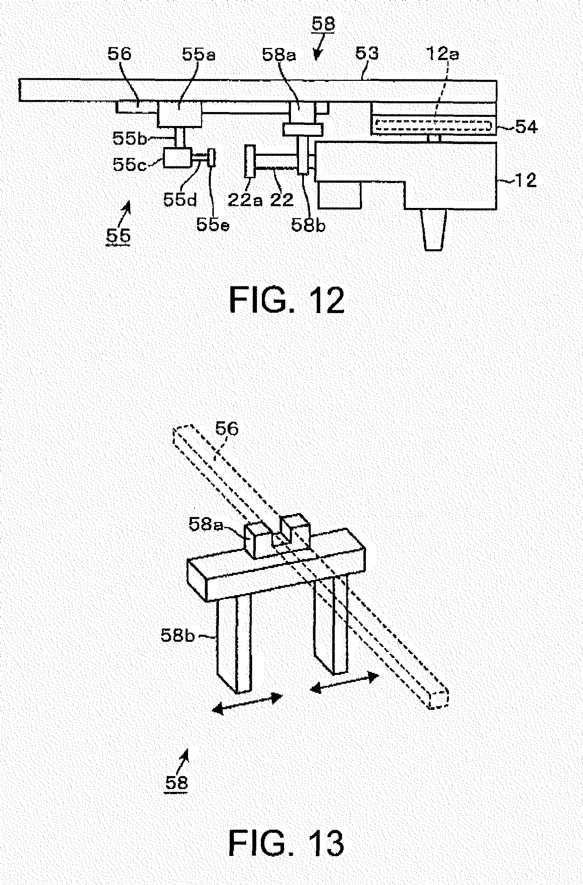

An actuating mechanism 55 is disposed on the lower surface of the arm unit 53 at a position away from the holder 54 toward the beam 52. The actuating mechanism 55 drives the shaft 22 of the cartridge 12 held by the holder 54 forward to the nozzle 21. To be specific, as shown in Fig. 12, the actuating mechanism 55 has a structure substantially equivalent to the replenishing mechanism 46, but turned upside down. The actuating mechanism 55 is configured to travel along a rail 56 formed on the lower surface of the arm unit 53 along the longitudinal direction of the shaft 22. The actuating mechanism 55 includes a base 55a, a support column 55b, a rotating mechanism 55c, a rotating shaft (driving unit) 55d and an engagement part 55e. The rotating mechanism 55c supports the rotating shaft 55d for rotation about the horizontal axis extending along the longitudinal direction of the shaft 22. The rotating shaft 55d is located at the same level (height position) as that of the shaft 22 of the cartridge 12 supported by the arm unit 53. Thus, like the replenishing mechanism 46 of the standby unit 13, by inserting the engagement part 55e into the hole 22b and by rotating the engagement part 55e at an angle (e.g., 90°) about the horizontal axis, the actuating mechanism 55 can hold the shaft 22 and move the shaft 22 forward and backward.

A release mechanism 58 for releasing the latches 27 of the shaft 22 is disposed between the actuating mechanism 55 and the holder 54. As shown in Fig. 13, the release mechanism 58 includes a pedestal 58a that moves along the rail 56 similarly to the actuating mechanism 55, and legs 58b, 58b extending downward from the lower surface of the pedestal 58a to sandwich therebetween the shaft 22 from both sides. The legs 58b are configured to be movable in the right and left direction (the direction perpendicular to the longitudinal direction of the shaft 22) by a not-shown driving mechanism disposed on the pedestal 58a. Thus, the shaft 22 can be moved toward the nozzle 21 in the following manner. Namely, by moving the legs 58b toward the shaft 22 with the cartridge 12 being held by the holder 54 and with the shaft 22 of the cartridge 12 being supported by the actuating mechanism 55, the latches 27 are released, whereby the shaft 22 can be moved toward the nozzle 21. After of the latches 27 has been released, the legs 58b are retracted to positions remote from the shaft 22 where the legs 58b are located on both sides (right and left sides) of the nozzle 21 of the cartridge 12, so that the legs 58b do not interfere with the forward movement of the actuating mechanism 55.

As shown in Fig. 1, a solvent nozzle 61 is disposed on the lower surface of the arm unit 53 at a position remote from the holder 54 in the longitudinal direction of the beam 52. The solvent nozzle 61 is configured to eject a solvent, such as a thinner, to a wafer W for performing a below-described, pre-wetting process. As shown in Fig. 1, a reservoir 63 storing a solvent is connected to the solvent nozzle 61 through a flexible (bellows-shaped) liquid supply passage 62, for example.

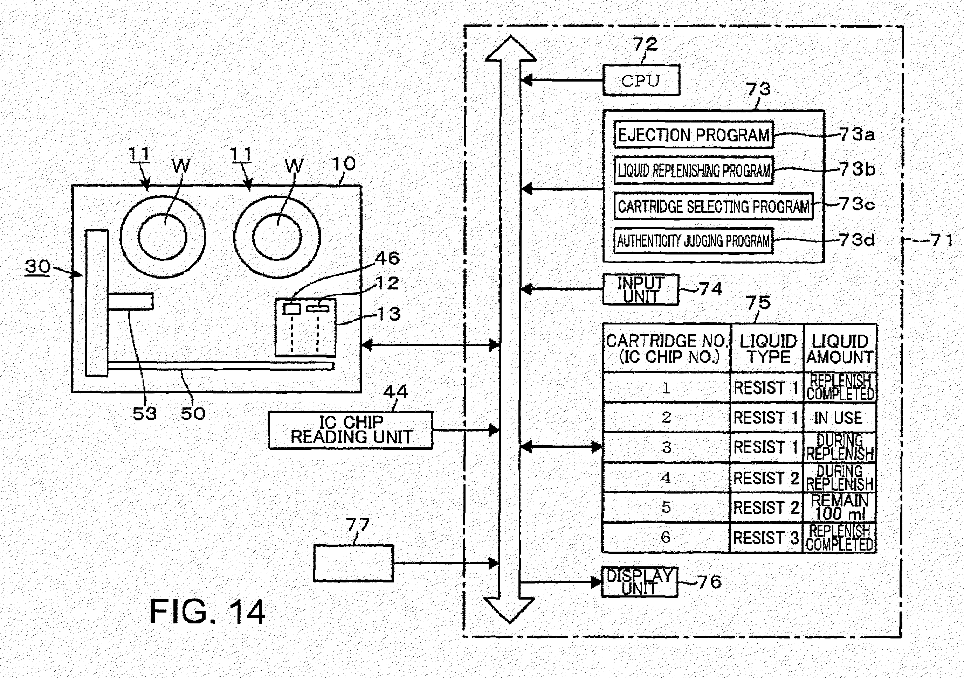

As shown in Fig. 14, the above-described liquid supplying apparatus is equipped with the control unit 71 that outputs control signals to the all the functional component parts of the apparatus. The control unit 71 includes a CPU 72, a program storing unit 73, an input unit 74, a memory 75 and a display unit 76. The program storing unit 73 stores an ejection program 73a for controlling ejection of the resist liquid to a wafer W, a liquid replenishing program 73b for controlling replenishment of the resist liquid to the cartridge 12, a cartridge selecting program 73c for controlling selection of cartridges 12, and an authenticity judging program 73d.

The input unit 74 is a unit through which an operator inputs the type of the resist liquid stored in the cartridge 12, when the use of the cartridge 12 is started upon starting-up of the apparatus, for example. The input unit 74 may be a keyboard, a mouse or the like for a personal computer. The memory 75 stores the number of each cartridge 12 (i.e., the identification number of the IC chip 12b) and the type of the resist liquid inputted through the input unit 74 such that they are correlated to each other. In addition, the memory 75 is configured to store an amount of the resist liquid remaining in each cartridge 12 in relation to the type of the resist liquid stored therein.

When each cartridge 12 is used in a resist-liquid ejecting process, the amount of the resist liquid used in the ejecting process which corresponds to the traveling distance of the shaft 22 can be detected. The memory 75 stores the amount of the resist liquid remaining in the cartridge 12, which is obtained by subtracting the amount of the used resist liquid from the initial amount of the resist liquid (i.e., the amount of the resist liquid stored in the cartridge 12 when the use of the one cartridge 12 was started). When the resist liquid is replenished to the cartridge 12 to fully fill the cartridge 12 according to the below-described liquid replenishing program 73b, the data of the remaining amount of the resist liquid stored in the memory 75 is reset so that the remaining amount data stored in the memory 75 becomes "full".

Fig. 14 shows cartridge numbers and types of the resist liquid of the six cartridges 12. Herein, the following situation is assumed. Resist 1 (resist of Type 1) is stored in the No. 1 to No. 3 cartridges 12. Resist 2 (resist of Type 2) which is different in type from the Resist 1 is stored in the No.4 and No. 5 cartridges 12. Resist 3 (resist of Type 3) which is different in type from the Resists 1 and 2 is stored in the No. 6 cartridge 12. The viscosity of the Resist 3 is lower than the viscosity of the Resist 2, and the viscosity of the Resist 2 is lower than the viscosity of the Resist 1. That is, Resist 1 has the highest viscosity.

It is also assumed the following. Replenishment of the resist liquid to the No. 1 and No. 6 cartridges 12 have been already completed, so that the remaining amount is "full" (i.e., the used amount is zero.). At this time, the No. 2 cartridge 12 is in use for the ejecting process of the resist liquid to a wafer W. Thus, the No. 2 cartridge 12 is not placed on the standby unit 13, so that the IC chip 12b cannot be read. The No.3 and No. 4 cartridges 12 each have therein a little amount of the resist liquid, and the resist liquid is being replenished thereto in the standby unit 13. The amount of the resist liquid remaining in the No.5 cartridge 12 is reduced to an amount that is smaller than before use (100 ml of the resist liquid remains in the No. 5 cartridge 12, for example).

The aforementioned ejecting program 73a is a program for execution of the wafer transportation and the resist liquid ejection, according to the type and the thickness of the resist film to be formed on the wafer W, based on recipes specifying various process parameters such as the type of the resist liquid to be used, the amount of the resist liquid to be ejected, the rotating speed of the wafer W and the time for maintaining the rotation of the wafer W. The liquid replenishing program 73b is configured such that, while monitoring (calculating) the remaining amount of the resist liquid in the cartridge 12 from the start of the use of the cartridge 12. When the remaining amount falls below a predetermined threshold value, the liquid replenishing program 73b performs the replenishing process in the standby unit 13. The time period required for the replenishment of the resist liquid can be known in advance through an experiment, for example. While the resist liquid is being replenished to the cartridge 12, the cartridge 12 is not available until the replenishment of the resist liquid is finished. At this time, data indicating "During Replenishment" is registered in the memory 75.

The cartridge selecting program 73c is a program for selecting one of the cartridges 12, which is used for the ejecting process of the resist liquid (the cartridge 12 is held by the arm unit 53 and transported). During execution of the resist liquid replenishment to a certain cartridge 12, this cartridge 12 is not available. In this case, when this cartridge 12 is desired to be used for a succeeding process, the arm unit 53 has to wait until the replenishment of the resist liquid is completed. However, standing-by of the arm 53 may result in reduction of the throughput of the apparatus. In addition, if the resist liquid has a higher viscosity, the flow resistance increases and thus bubbles are likely to be generated in the resist liquid, so that there is greater difficulty in the feeding of the resist liquid. As a result, the replenishment completion waiting time lengthens.

In order to cope with this situation, among the six cartridges 12, three cartridges 12 are assigned to the Resist 1 having the highest viscosity, and two cartridges 12 are assigned to the Resist 2 having the second highest viscosity. Thus, if one of the cartridges assigned to the Resist 1 (or 2) is being replenished with the Resist 1 (or 2) when the Resist 1 (or 2) needs to be ejected, an available cartridge 12 (in which the Resist 1 (or 2) remains) other than the cartridge 12 during replenishment is selected.

To be specific, a case where the Resist 2 needs to be ejected is explained. As shown in Fig. 14, one (No. 4 cartridge) of the two cartridges 12 for Resist 2 is being replenished and thus unavailable, and the Resist 2 remains in the other cartridge (No. 5) 12 for resist 2. The cartridge selecting program 73c gives an instruction to the transport mechanism 30 not to use the unavailable cartridge 12 but use the other cartridge (No. 5) 12 which is filled with the resist liquid of the same type as that of the resist liquid in the unavailable cartridge 12.

The authenticity judging program 73d judges whether the cartridge 12 placed on the standby unit 13 is a genuine product, or an altered or imitation product. When a cartridge 12 on which the IC chip 12b is not applied is placed on the standby unit 13, the type of the resist liquid cannot be read from the cartridge 12. Thus, the operation is performed on the assumption that no cartridge 12 is placed on the standby area 31 on which such a cartridge 12 is placed.

Meanwhile, in a case where an imitated IC chip 12b is applied to a cartridge 12, the IC chip 12b does not store data showing that the cartridge 12 is a genuine product. When such a cartridge 12 is placed on the standby area 31, the authenticity judging program 73d causes the display unit 76 to display an alarm urging to stop the use of the altered or imitated cartridge 12, and issue instructions to stop the operation of the apparatus until the alarm disappears. These programs 73a to 73d respectively have steps for performing below-described operations of the apparatus. The programs 73a to 73d are installed to the control unit 71 from the storage unit 77 which is storage medium such as a hard disc, a compact disc, a magneto-optical disc, a memory card, a flexible disk, etc.

Next, the operation of the liquid supplying apparatus is explained. At the start-up of the apparatus, the operator places the cartridges 12 each filled with the resist liquid on the standby unit 13, and each reservoir 43 of the standby unit 13 is filled with the corresponding resist liquid. The shaft 22 of each cartridge 12 is immovably locked by the latches 27 at a position away from the nozzle 21. The replenishing mechanism 46 of each standby unit 13 is standing-by at a positon remote from the corresponding cartridge 12. The feed pump 42 of each standby unit 13 is driven in advance such that the resist liquid level in the standby unit 13 reaches the protrusion 40, in order to prevent air from entering the cartridge 12 when the resist liquid is replenished. The operator inputs the type of the resist liquid stored in each cartridge 12 through the input unit 74. The memory 75 stores the identification number of the IC chip 12b of each cartridge 12 and the type of the corresponding resist liquid such that they are correlated to each other, and also stores data showing that each cartridge 12 is filled with the resist liquid.

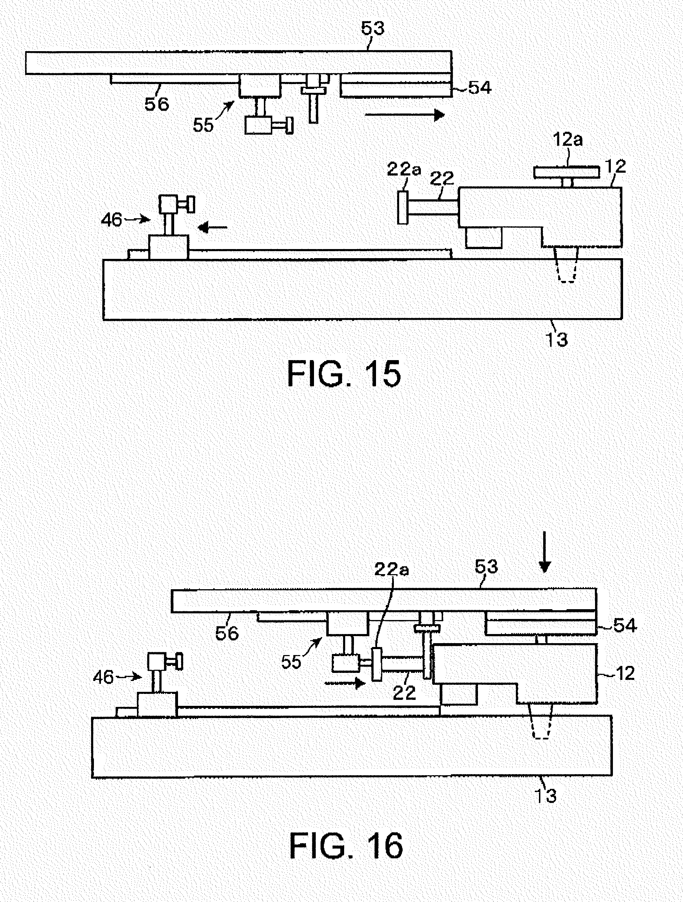

Then, a wafer W is held on the spin chuck 14 by a not-shown transport arm. Depending on the type of a resist film to be formed on the wafer W, in other words, depending on the recipe, the transport mechanism 30 is moved toward one of the cartridges 12 storing the resist liquid to be used. As shown in Fig. 15, the transport mechanism 30 stops the arm unit 53 at a position where the actuating mechanism 55 is placed just before the shaft 22 of the cartridge 12 such that the actuating mechanism 55 does not interfere with the shaft 22. As shown in Fig. 16, the arm unit 53 is then lowered to a height position at which the arm unit 53 can hold the cartridge 12. Then, the holder 54 is moved forward to a position facing the tab 12a, and the holder 54 holds the cartridge 12. The actuating mechanism 55 is then moved forward to be engaged with the shaft 22.

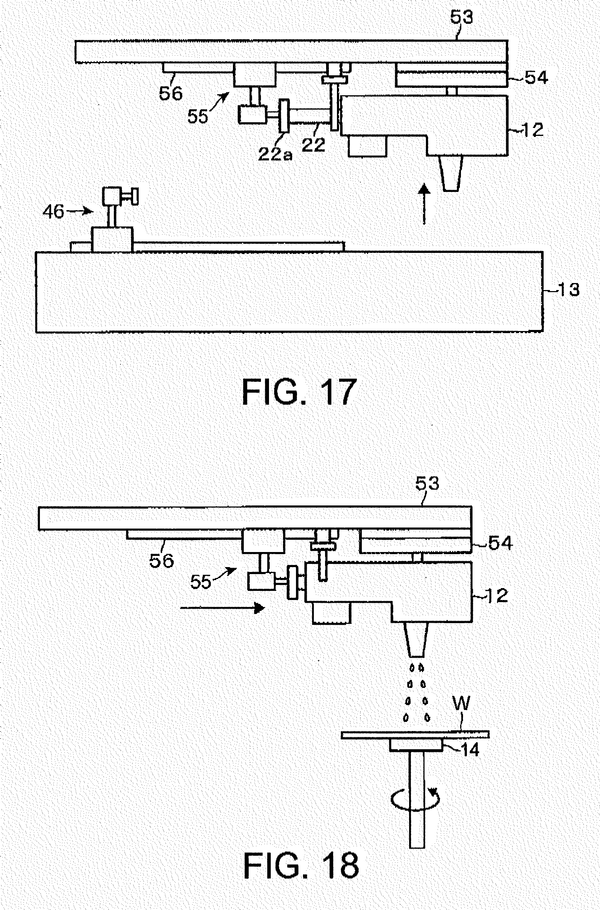

Thereafter, the arm unit 53 is moved upward. Thus, as shown in Fig. 17, the cartridge 12 is lifted up from the standby unit 13. The transport mechanism 30 transports the cartridge 12 to the processing unit 11 where the wafer W is held, such that the solvent nozzle 61 is positioned to face the central portion of the wafer W. Then, a solvent is supplied onto the wafer W which is rotating about the vertical axis to perform a so-called pre-wetting process, by which the surface of the wafer W is wetted with the solvent.

Following thereto, as shown in Fig. 18, the arm unit 53 is moved such that the nozzle 21 of the cartridge 12 is opposed to the central portion of the wafer W, and the latches 27 are unlocked. After that, the shaft 22 is moved forward by the actuating mechanism 55, so that the resist liquid is ejected to the surface of the wafer W. Since the surface of the wafer W has been already coated with the solvent in the pre-wetting process, the resist liquid and the solvent are mixed with each other, so that the resist liquid is uniformly applied to the surface of the wafer W. After a required amount of the resist liquid has been ejected to the wafer W, the actuating mechanism 55 is stopped to fix the position of the wall surface part 25. In addition, since the resist liquid is suctioned upward by the suck-back valve 24b from the ejecting port of the nozzle 21, no excessive resist liquid falls onto the wafer W.

The wafer W coated with the resist film is unloaded from the processing unit 11 by the not-shown transport arm. Then, another unprocessed wafer W is transported to the processing unit 11. If the recipe of the unprocessed wafer W is the same as that of the preceding wafer W (when the resist liquid of the same type is to be applied), the resist liquid is applied in the same manner, with the use of the cartridge 12 which has been already held by the arm unit 53.

On the other hand, when the resist liquid of another type is used, the cartridge 12 is replaced with another one in the following manner. Namely, the shutoff valve 24a is closed, and then the arm unit 53 returns the cartridge 12 held by the arm 53 to the original standby area 31, according to the sequence reverse to the sequence for taking out this cartridge 12 from the standby area 31. In detail, the transport mechanism 30 is moved to place the cartridge 12 above the corresponding standby area 31, and lowers the cartridge 12 to place it in contact with the standby area 31. Thereafter, the engagement of shaft 22 with the actuating mechanism 55 and the engagement of the cartridge 12 with the holder 54 are released.

After that, the arm unit 53 is moved backward to a position at which the actuating mechanism 55 and the shaft 22 do not interfere with each other, and then the arm unit 53 is moved upward, leaving the cartridge 12 placed on the standby area 31. In the cartridge 12 returned to the standby area 31, since the wall surface part 25 is located near the nozzle 21, the restoring force (resilient force) of the bellows body 26 urges the wall surface part 25 toward the shaft 22 side, and such a motion of the wall surface part 25 may result in a situation where atmospheric air is drawn into the cartridge 12 via the check valve 29. However, since the projection 40 is air-tightly in contact with the lower part of the check vale 29, no or very little atmospheric air is drawn into the cartridge 12.

Then, the arm unit 53 is moved to a position above the cartridge 12 to be used next, and the cartridge 12 is lifted up like the prior cartridge 12. Thereafter, the resist liquid coating process is performed in the same manner as described above. In selecting a cartridge 12 to be used next, if the cartridge 12 desired to be used next is being replenished with the resist liquid so that the cartridge 12 is unavailable, the arm unit 53 is operated in the following manner.

That is, if another cartridge 12, which stores the resist liquid of the same type as that of the resist liquid to be used next, is placed on the standby unit 13 (when the resist liquid to be used next is the Resist 1 or the Resist 2), the arm unit 53 does not take the unavailable cartridge 12 but takes the available cartridge 12. On the other hand, if the cartridge 12 desired to be used next is being replenished with the resist liquid, and there is no cartridge 12 of the same type on the standby unit 13 (when the Resist 3 is used), the arm unit 53 stands-by above the standby area 31 until the replenishment of the resist 3 is completed.

In the standby unit 13 to which the used cartridge 12 is returned, a liquid thinner is supplied to the nozzle 21 to clean the nozzle 21. In addition, due to a solvent atmosphere generated by the thinner, the inside of the nozzle 21 of the cartridge 12 placed on the standby unit 13 is prevented from being dried. As has been already described in detail, in the standby unit 13, the remaining amount of the resist liquid is calculated based on the identification number of the IC chip 12b. When the remaining amount is not more than the predetermined threshold value, replenishment of the resist liquid is performed. That is, the replenishing mechanism 46 is moved forward to the cartridge 12 and is engaged with the shaft 22 as shown in Fig. 10.

Since the check valve 29 of the cartridge 12 and the processing liquid replenishing passage 41 are airtightly connected via the sealing member 40a while the shutoff valve 24a is closed, the resist liquid is suctioned upward from the processing liquid replenishing passage 41, as shown in Fig. 10, by moving the shaft 22 backward, whereby the reservoir chamber 23 is filled with the resist liquid. When the latches 27 are engaged with the periphery of the opening 22c of the cartridge 12 by moving the shaft 22 backward, the replenishment of the resist liquid to the cartridge 12 is completed. After the replenishment of the resist liquid has been completed, the replenish mechanism 46 is retracted (moved backward) to a position at which the replenish mechanism 46 does not interfere with the operation of the arm unit 53 for taking out the cartridge 12.

In this manner, the liquid supplying apparatus performs resist film coating processes to wafers W according to the corresponding recipes for the respective wafers W, while changing the resist liquid to be used and while replenishing the resist liquid into the cartridge 12 as needed basis. During the operation in which one of the cartridge 12 storing the Resist 1 (or 2) held by the arm unit 53 ejects the Resist 1 (or 2) to a plurality of wafers W successively, when the amount of the resist liquid remaining in the cartridge 12 becomes insufficient, the cartridge 12 is replaced with another one in the same manner as mentioned above. In detail, the arm unit 53 returns the used cartridge 12 to the original standby area 31, then the arm unit 53 picks up another cartridge 12 of the same type so as to process a succeeding wafer W. Then, the resist liquid is replenished to the vacant cartridge 12 in the same manner as describe above.

In the aforementioned embodiment, the reservoir chamber 23 storing the resist liquid and the nozzle 21 for ejecting the resist liquid are integrated with each other as the cartridge 12. In addition, the cartridge 12 is transported from the standby unit 13 to a position right above a wafer W, and the resist liquid is ejected from the cartridge 12. Moreover, the replenish port 28 for replenishing the resist liquid to the cartridge 12 is provided separately from the nozzle 21 for ejecting the resist liquid. Thus, when the resist liquid is replenished to the cartridge 12, contamination of the nozzle 21 can be suppressed. Namely, when a highly viscous processing liquid (resist liquid) adheres to an outer surface of the nozzle 21, it is difficult to remove such a processing liquid only by spraying a solvent such as a thinner to the nozzle 21. Thus, if a highly viscous processing liquid is replenished through the nozzle 21, in other words, if a port is commonly used for ejecting the resist liquid and for replenishing the resist liquid, an extra operation such as a wiping operation by the operator is needed after the replenishing process, and thus the number of process steps increases and the throughput of the apparatus decreases. On the other hand, in the foregoing embodiment, since the replenishing port 28 is provided separately from the ejecting port (nozzle 21) for ejecting the resist liquid, contamination of the nozzle 21 can be prevented, avoiding the reduction of throughput.

In addition, in the foregoing embodiment, the actuating mechanism 55 for pushing the processing liquid (resist liquid) is not disposed on the end portion of a long pile extending from the nozzle 21, but is disposed near the nozzle 21. Namely, in operation, the actuating mechanism 55 integrated with the arm unit 53 is disposed near the nozzle 21. Thus, in the foregoing embodiment, since the resist liquid can be ejected without using any pipeline, even if the mechanism for driving the resist liquid (actuating mechanism 55) do not have a high performance, the resist liquid can be ejected at a high ejecting rate. To be more specific, in a case where the viscosity of the resist liquid is 10000 cP, the ejecting rate of the resist liquid is 2 ml/s, the internal diameter of the nozzle 21 is $\phi$4.5 mm, and the length of the nozzle 21 is 50 mm, the pressure loss occurred when the resist liquid is ejected from the nozzle 21 is 0.1 MPa, which is significantly smaller than the pressure loss occurred in a case where the resist liquid is supplied to the nozzle through a long pipe. Thus, even when a wafer W having a diameter as large as 400 mm is processed and/or even when a resist liquid (processing liquid) having a viscosity as high as 1000 cP or more (e.g., 1000 cP to 4000 cP), the resist liquid can be ejected smoothly. It is not necessary to complicate the structure of the apparatus to achieve the above-described performance.

In addition, unlike conventional structures in which different pipes and different pumps are provided for different types of resist liquids, in the foregoing embodiment, one pumping mechanism (actuating mechanism 55) is shared by a plurality of cartridges 12 for ejecting different types of resist liquid, the apparatus can be manufactured at a lower cost. Further, since the apparatus substantially do not have any pipes, a higher degree of freedom in layout of the apparatus component member is achieved, and leakage of resist liquid from the joint of piping can be avoided.

In addition, the replenishing mechanism 46 for replenishing the resist liquid to the cartridge 12 is provided separately from a mechanism for ejecting the resist liquid (actuating mechanism 55). Further, a plurality of cartridges 12 are prepared for a highly viscous resist liquid (Resists 1 and 2). Thus, while the resist liquid is being replenished to one of the cartridges 12, the ejecting process of the resist liquid can be performed. Thus, it is not necessary to interrupt the process until the replenishment of the resist liquid is completed. Moreover, the replenishing rate at which the resist liquid is replenished to the cartridge 12 can be set slower to such a rate that ensures that no bubbles are generated in the resist liquid. Thus, as compared with a case in which the ejection and the replenishment of the resist liquid is carried out by one pumping mechanism, the operation for removing bubbles can be omitted or shortened, whereby the throughput of the apparatus can be improved further. In addition, the amount of the resist liquid that must be discarded in the bubble removal operation can be reduced to zero or a very small amount.

Furthermore, as compared with a case in which a long pipe for feeding the resist liquid is used, it is not difficult to use a clean material, such as quartz, which rarely produces particles, for the resist liquid-contacting members arranged between the shaft 22 and the nozzle 21 (for forming spaces in which the resist liquid flows) can be formed of a clean material such as quartz which rarely produces particles. Namely, such a clean material is so expensive that it is difficult to use the clean material for a long pipe. However, due to the substantially pipeless structure as described above, the clean material can be used at an acceptable cost. In addition, since the resist liquid-contacting area (processing liquid-contacting area) is small, the area can be easily cleaned. That is, even in a case where a processing liquid such as a polyimide which is easily solidified is used, or the cartridge 12 is left for a long period of time, the processing liquid-contacting area can be cleaned without difficulty. Thus, it is easy to restart the apparatus. Moreover, since the processing liquid-contacting area is small, the whole parts associated with the processing liquid-contacting area can be replaced at a low cost.

If a not-shown replenishing tool for replenish the resist liquid to the cartridge 12 (a tool including the processing liquid replenishing passage 41 and the replenishing mechanism 46) is prepared, the degree of freedom of the apparatus operation can be improved. For example, an evaluation of a resist liquid is performed easily and simply by charging (replenishing) the resist liquid to be evaluated into the cartridge with the use of the not-shown replenishing tool. In this case, it is not necessary to cause the resist liquid for evaluation to flow through the standby unit 13.

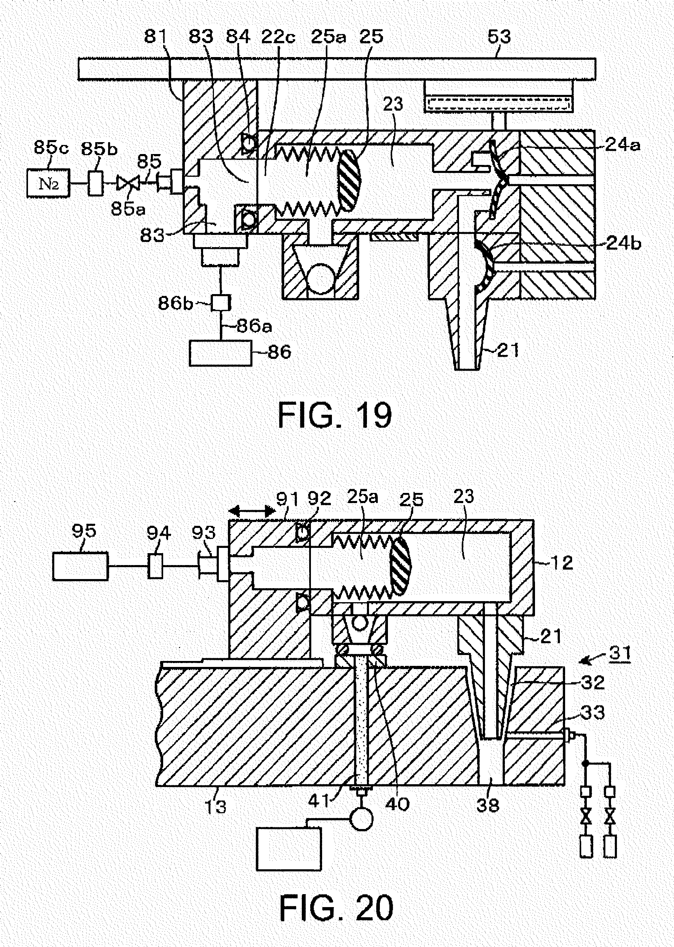

Next, another embodiment of the present invention is described. The arm unit 53 in this embodiment has a mechanism for driving the wall surface part 25 by using a gas, in place of the aforementioned actuating mechanism 55 that mechanically drives the shaft 22. To be specific, as shown in Fig. 19, the cartridge 12 is not equipped with the shaft 22 in this embodiment, while there is a large space 25a behind the wall surface part 25. The space 25a is hermetically sealed off from the reservoir chamber 23. A hollow housing 81 is disposed on the lower surface of the arm unit 53 to supply and discharge a gas (e.g., nitrogen gas or air) to and from the space 25a.

The housing 81 has openings 83 in communication with the interior of the housing 81 in a side surface thereof facing the cartridge 12 and in a lower surface thereof, respectively. A sealing member 84, such as an O-ring, is provided around the circumference of the openings 83 on the side of the cartridge 12, whereby opposing outer wall surfaces of the carriage 12 and the housing 81 can be air-tightly connected to each other.

One end of a supply pipe 85, which is included in a gas supply mechanism for supplying the gas, is connected to a wall surface of the housing 81 on the side farther from the cartridge 12. The other end of the supply pipe 85 connected to a gas reservoir (gas source) 85c via a valve 85a and a flow rate regulating unit 85b. An exhaust passage 86a, which is connected to an exhaust mechanism 86 such as a vacuum pump, is connected to the opening 83 in the lower surface of the housing 81. A pressure regulating unit 86b, such as a butterfly valve, is provided in the exhaust passage 86a. Thus, when the gas is supplied from the supply pipe 85 to the space 25a, the wall surface part 25 is moved forward. On the other hand, when the space 25a is evacuated, the wall surface part 25 is moved backward. After the resist liquid has been ejected from the nozzle 21, the forward movement and the backward movement of the wall surface part 25 is stopped by balancing the force that drives the wall surface part 25 forward and the force that drives the wall surface part 25 backward by controlling the pressure in the space 25 by supplying/discharging the gas to and from the space 25a.

The standby unit 13 also has a mechanism for moving backward the wall surface part 25 by using a gas. In detail, as shown in Fig. 20, a housing 91 of a substantially box shape is disposed, in place of the replenishing mechanism 46. A side surface of the housing 91 facing the cartridge 12 has an opening. A sealing member 92, such as an O-ring, is provided around the opening of the housing 91, whereby the cartridge 12 and the housing 91 are air-tightly connected to each other.

One end of an exhaust passage 93, which is included in a suction mechanism for exhausting the housing 91, is connected to a side surface of the housing 91 on the side farther from the cartridge 12. An exhaust mechanism 95 is connected to the other end of the exhaust passage 93 via a pressure regulating unit 94. By evacuating the housing 91 by the exhaust mechanism 95, the wall surface part 25 can be moved backward. The housing 91 is equipped with a not-shown urging mechanism formed of, e.g., a spring for urging the housing 91 away from the cartridge 12. Thus, when the negative pressure established by the exhaust mechanism 95 is released, the housing 91 moves away from the cartridge 12 by the urging force by the urging mechanism. On the other hand, when the evacuation by the exhaust mechanism 95 is started, the outside air is drawn into the housing 91, and a negative pressure is generated by the airflow between the housing 91 and the cartridge 12, whereby the housing 91 moves toward the cartridge 12 to come into air-tight contact with the cartridge 12.

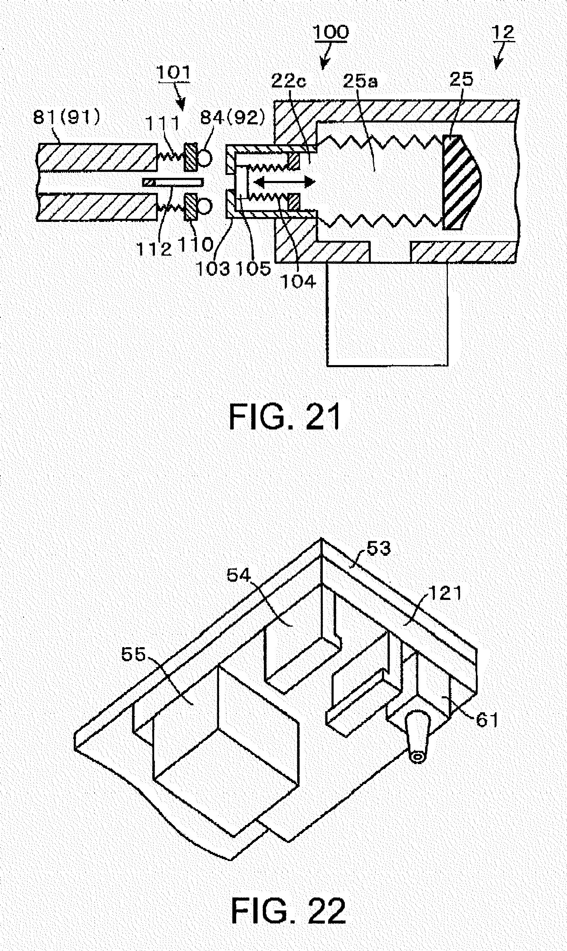

In addition, although omitted in Figs. 19 and 20 for simplicity of the drawings, the cartridge 12 is equipped with a locking mechanism 100 that locks the movement of the wall surface part 25, and each of the housings 81 and 91 is equipped with a release mechanism 101 that releases locking of the locking mechanism 100. To be specific, as shown in Fig. 21, a cylindrical body 103 extending along the longitudinal direction of the cartridge 12 is air-tightly inserted into the opening 22c of the cartridge 12. One of both longitudinal ends of the cylindrical body 103 facing the wall surface part 25 extends along the periphery of the opening 22c of the cartridge 12 and has an opening having a diameter similar to (slightly smaller than) the opening 22c of the cartridge 12. On the other hand, the other longitudinal end of the cylindrical body 103 facing the outside area of the cartridge 12 has an opening having a diameter smaller than that of the opening 22c.

A bellows body 104, which is expandable/contractible along the longitudinal direction of the cylindrical body 103, is received within the cylindrical body 103. The bellows body 104 is resiliently compressed in the cylindrical body 103 so that the bellows body 104 tends to expand in the longitudinal direction. One end of the bellows body 104 facing the wall surface part 25 is air-tightly fixed to the cylindrical body 103 circumferentially along the inner circumferential surface thereof. A sealing member 105 having a circular disc shape is connected to the other end of the bellows body 104 away from the wall surface part 25. The sealing member 105 moves forward and backward in conjunction with the expansion and compression of the bellows body 104. The sealing member 105 moves forward and backward between a position at which the sealing member 105 is in sealing contact with the other end of the cylindrical body 103 (i.e., a seat on which the sealing member 105 is seated) and a position remote from the contact position toward the wall surface part 25. Thus, under the condition in which no external force is applied to the bellows body 104 and the sealing member 105, the sealing member 105 and the cylindrical body 103 are in sealing contact with each other, so that the space 25a is isolated from the outside (i.e., the atmosphere outside the cartridge 12) to lock the movement of the wall surface part 25. On the other hand, when the sealing member 105 is moved away from the seat of the cylindrical body 103 toward the nozzle 21, the space 25a is communicated with the outside of the cartridge 12, so that a gas can be supplied to and discharged from the space 25a.

As shown in Fig. 21, the sealing member 84 (92) is air-tightly connected to the housing 81 (91) via a bellows body 111, such that the sealing member 84 (92) can be moved forward and backward. In detail, one end of the bellows body 111 is air-tightly fixed on a side surface of the housing 81 (91) facing the cartridge 12, while the other end of the bellows body 111 is air-tightly connected to an annular member 110 in which the sealing member 84 (92) is embedded. A rod 112 is surrounded by the bellows body 111, and extends horizontally from the housing 81 (91) toward the cartridge 12. The proximal end of the rod 112 is fixed to the housing 81 (91). The distal end of the rod 112 extends beyond the sealing member 84 (92) toward the cartridge 12.

Thus, when the housing 81 (91) approaches the cartridge 12, the sealing member 84 (92) is brought into sealing contact with the cylindrical body 103. Then, the housing 81 (91) is further moved toward the cartridge 12, the rod 112 pushes the sealing member 105 toward the nozzle 21 side with the housing 81 (91) being in sealing contact with the cartridge 12, so that the internal space of the housing 81 (91) and the space 25a are communicated with each other. Thus, supplying and evacuating of a gas via the housing 81 (91) is enabled. As is apparent from the above description, also in the embodiment of Fig. 19 to 21, the same operations for replenishing and ejecting the resist liquid as those in the previously-described embodiment can be achieved.

Next, yet another embodiment of the present invention is described. In this embodiment, the apparatus is configured to adjust a thickness of a resist film to be formed on a wafer W, based on an amount of a resist liquid to be used (ejected) to the wafer W (used amount or ejection amount). To be specific, as shown in Fig. 22, a planar weight measuring unit 121 is disposed on a lower side of the arm unit 53 to support the holder 54, the solvent nozzle 61 and the actuating mechanism 55.

The weight measuring unit 121 is formed by two planar bodies that are vertically opposed to each other. A plurality of resilient members, such as springs, are interposed between the planar bodies, and are distributed in the plane of the planar bodies. The vertical distance between the planar bodies can be measured by a suitable measuring device such as camera. The measured distance is transmitted to the control unit 71. The weight of the resist liquid in the cartridge 12 is calculated by subtracting total weights of the holder 54, the solvent nozzle 61 and the arm unit 53 from the weight measured by the measuring unit 121. In Fig. 22, the weight measuring unit 121 is illustrated schematically.

Namely, as described above, the amount of the resist liquid ejected to a wafer W from the nozzle 21 can be detected by the controller 71 based on the moving distance at which the wall surface part 25 is moved forward toward the nozzle 21. However, in a process which requires precise control of the resist film thickness, it is preferable that the ejection amount of the resist liquid can be monitored by another measurement system in addition to the aforementioned distance based measurement system, and also preferable that the thickness of the resist film can be adjusted. In this embodiment, the arm unit 53 is provided with the weight measuring unit 121 that measures the weight of the resist liquid, and the thickness of the resist film can be adjusted in accordance with the below-described sequence.

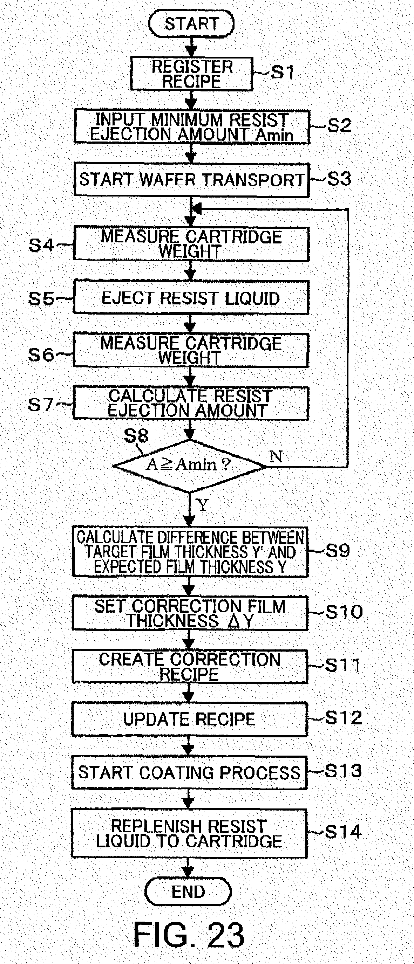

Specifically, as shown in Fig. 23, a process recipe of a wafer W specifying the type and the thickness of a resist film is firstly registered (step S1). Then, the minimum resist ejection amount "Amin" is inputted to the control unit 71 by using, for example, the input unit 74 (step S2). The term "minimum resist ejection amount (Amin)" means an ejection amount below which the resist film thickness is no longer controlled. Thus, if an amount of the resist liquid ejected from the nozzle 21 is not less than the minimum resist ejection amount "Amin", the film thickness can be adjusted according to the following sequence. On the other hand, when the ejection amount is less than the minimum resist ejection amount "Amin", it is difficult (or impossible) to control the film thickness.

Then, transport of a wafer W to the processing unit 11 is started (step S3). The cartridge 12 filled with the resist liquid is held by the arm unit 53 beforehand, and the weight of the cartridge 12 is measured before ejection of the resist liquid (step S4). After that, the spin chuck 14 is rotated at a low rotating speed (or is stopped) such that the resist liquid does not spread on the surface of the wafer W. Under this condition, the resist liquid is ejected from the nozzle 21 (step S5), in the manner as previously described in detail. Thereafter, the weight of the cartridge 12 is measured again (step S6). Note that, prior to the ejection of the resist liquid, the aforementioned pre-wetting process is performed (description thereof is omitted.).

Then, the weight A of the resist liquid having been ejected from the nozzle 21 is calculated by subtracting the weight of the cartridge 12 after ejection of the resist, from the weight of the cartridge 12 before ejection of the resist (step S7). If the calculated weight A is not less than the value corresponding to the minimum resist ejection amount Amin (measured by weight) (Yes in step S8), it is judged that the thickness of a resist film can be adjusted and thus the program proceeds to the next step. On the other hand, if the weight A of the resist liquid is less than the value corresponding to the minimum resist ejection amount Amin (measured by weight) (No in step S8), it is judged that the resist liquid existing on the surface of the wafer W is insufficient for adjusting the thickness of the resist film. In this case, the ejection of the resist liquid and the weight measurement of the cartridge 12 before and after the resist liquid ejection are performed. Then, the steps S4 to S8 are repeated until the sum of the newly obtained weight A and the previously obtained weight(s) A becomes not less than the weight Amin (measured by weight).

Following thereto, the difference between the target film thickness Y' and the expected film thickness Y, which is expected from the already calculated weight A, is calculated (step S9). The target film thickness Y' is set in the recipe beforehand. As described in detail in the "Example" section later, the expected film thickness Y can be obtained by substituting X in Expression (1) (described later) with the weight A.

After the difference $\Delta Y$ ($\Delta Y = Y' - Y$) has been calculated, the difference is set as a correction thickness (step S10), and a correction recipe is determined. To be specific, as will be understood from the "Examples" described later, the thickness of the resist film can be adjusted by adjusting at least one of the following parameters: the rotating speed of the wafer W and the time in which the rotation of the wafer W is maintained (hereinafter referred to as "rotating time"). As compared with the rotating time, the rotating speed of the wafer W has a larger impact on the thickness of the resist film, that is, the adjustment of the rotating speed allows a wider range of adjustment of the resist film thickness. Thus, the correction recipe is created as follows. It is judged through calculation whether the film thickness can be adjusted only by adjusting the rotating speed of the wafer W ($\Delta x1$). If it is judged that the film thickness cannot be adjusted only by adjusting the rotating speed of the wafer W, the rotating time of the wafer W ($\Delta x2$) is also adjusted in addition to the rotating speed of the wafer W.

Thereafter, the recipe is updated such that the correction recipe thus obtained according to the above is substituted for the old recipe (the recipe before updated) (step S12). To be specific, in a case where the rotating speed of the wafer W is "x1" while the rotating time of the wafer W is "x2" in the old recipe, the rotating speed of the wafer W becomes "x1"+"$\Delta x1$" and the rotating time of the wafer W becomes "x2"+"$\Delta x2$" in the updated recipe. By rotating the wafer W about the vertical axis according to the thus obtained recipe, the resist liquid spreads outwardly over the surface of the wafer W and the excessive amount of resist liquid is spun off, so that a resist film of the desired thickness is formed on the wafer W (step S13). Since the aforementioned steps succeeding to the step S7 are performed by the control unit 71 promptly and rapidly, there is no possibility that the resist liquid becomes dried and solidified on the surface of the wafer W.

After that, when the remaining amount of the resist liquid in the cartridge 12 becomes insufficient, the resist liquid is replenished to the cartridge 12 (step S14) in the above-described manner. The processed wafer W is unloaded from the processing unit 11, and another unprocessed wafer W is loaded into the processing unit 11 so as to be processed in accordance with the steps S3 to S14.

By adjusting a thickness of a resist film in the above-described manner based on the actual weight of the resist liquid ejected to a wafer W, even when there are bubbles in the resist liquid stored in the cartridge 12 or when the resist liquid is erroneously ejected from the nozzle 21, the thickness of the resist film can be adjusted to a value that is expected by the recipe. Although in the above embodiment employing the weight measuring unit 121 the correction amount is calculated while the resist liquid is being placed on the wafer W, the following operation is also possible. Namely, this wafer is processed at the rotating speed for the rotating time specified by the old (not updated) recipe, and the succeeding wafer is processed in accordance with a recipe that is updated according to the above-described manner through calculation. In this case, after a resist film has been formed on one wafer W, the difference of the expected film thickness Y which is expected from the actual weight of the resist liquid ejected to the one wafer W from the target film thickness Y' is calculated. Then, the rotating speed and the rotating time are corrected such that the difference of thickness becomes zero, and the corrected rotating speed and rotating time are applied to the wafers W succeeding to the one wafer W.

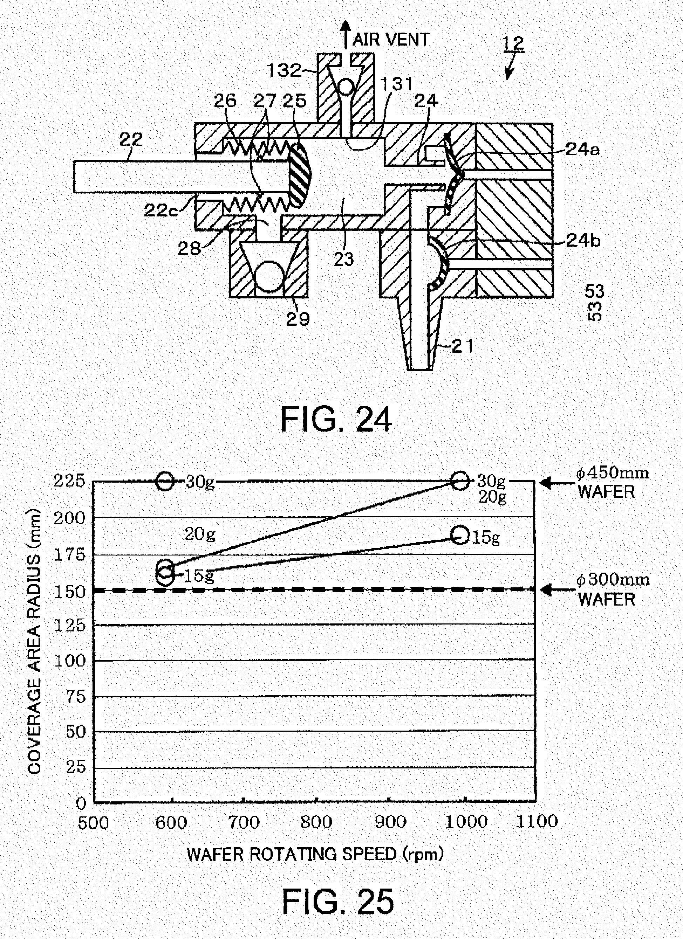

Fig. 24 shows still yet another embodiment in which the above-described cartridge 12 is further provided with a mechanism for discharging bubbles if bubbles are contained in a space where the resist liquid flows. If there are bubbles between the lower surface of the check valve 29 and the upper end of the processing liquid replenishing passage 41 when the cartridge 12 is placed on the standby unit 13, there is a possibility that the bubbles are taken into the cartridge 12 together with the resist liquid. In order to address such a problem, in the embodiment of Fig. 24, the top surface of the cartridge 12 is provided with an opening in communication with the reservoir chamber 23, and a check valve 132 is disposed above the opening 131. Although the shaft 22 moves the the wall surface part 25 forward and backward in the cartridge 12 shown in Fig. 24, another mechanism for moving the wall surface part 25 such as those shown in Figs. 19 to 21 is possible.

When the resist liquid is drawn into the cartridge 12 of Fig. 24, the bubbles gather near the top surface of the cartridge 12, specifically in the vicinity of the opening 131. Therefore, the shaft 22 is moved forward with the shutoff valve 24a being closed, the bubbles are discharged through the check valve 132. Thereafter, the shutoff valve 24a is opened, the resist liquid in the cartridge 12 moves not toward the check valve 132 but toward the nozzle 21 by the gravity, whereby the resist liquid is ejected to a wafer W in the same manner as described above.

In the respective embodiments, although the resist liquid is replenished to the cartridge 12 in the standby unit 13, a transport unit such as a movable cart may be provided, and an operator may replenish the resist liquid by the transport unit, for example. In addition, in the step of replenishing the resist liquid to the cartridge 12, if the cartridge 12 becomes unusable due to clogging of the replenishing port 28 for example, the cartridge 12 may be replaced with an unused new cartridge 12.

Although the processing liquid handled by the liquid supplying apparatus is a resist liquid in the foregoing embodiments, the processing liquid may be a liquid comprising a polyimide resin, or an adhesive solution which is used for adhering wafers W to each other in the thickness direction. Alternatively, the processing liquid may be a solvent such as a thinner, and a pre-wetting process may be performed to a wafer W by using the cartridge 12 filled with the solvent. When the pre-wetting process is performed by using the cartridge 12 filled with a solvent, another holder (not shown) may be disposed besides the holder 54, such that the arm unit 53 can hold the cartridge 12 for resist liquid and the cartridge 12 for solvent at the same time.

A piston-cylinder mechanism may be used instead of the aforementioned structure comprising the shaft 22 and the wall surface part 25. Namely, the outer circumferential surface of the wall surface part 25 may be in sealing contact with an inner wall surface of the reservoir chamber 23, so that the resist liquid can be pushed out by the wall surface part 25. In this case, the replenishing port 28 is positioned nearer to the nozzle 21 than the moving range of the wall surface part 25. Alternatively, the replenishing port 28 and the nozzle 21 may be positioned nearer to the proximal end of the arm unit 53 than the movement range of the wall surface part 25, such that the resist liquid is replenished into the cartridge 12 when the shaft 22 is moving forward, while the resist liquid is ejected when the shaft 22 is moving backward. Although the replenishing port 28 and the nozzle 21 are arranged side by side in the foregoing embodiments, the replenish port 28 may be formed above the nozzle 21 to configure a so-called, vertical-type cartridge.

In the foregoing embodiments, a negative pressure (suction force) generated in the cartridge 12 by moving backward the wall surface part 25 is used to replenish the resist liquid into the cartridge 12. However, the replenishment of the resist liquid may be performed by pumping the resist liquid pressurized by the feed pump 42 into the cartridge 12. Although the shutoff valve 24 is formed as a diaphragm valve driven by air, the shutoff valve 24 may be a check valve that does not allow the resist liquid to return from the nozzle 21 to the reservoir chamber 23.

In the foregoing embodiments, the replenishing mechanism 46 (or housing 91) disposed on the standby unit 13 moves the wall surface part 25 backward to replenish the resist liquid into the cartridge 12. However, the wall surface part 25 may be moved backward by the actuating mechanism 55 (housing 81) of the arm unit 53. That is, the mechanism for pushing out the resist liquid in the cartridge 12 toward the nozzle 21 may also serve as the mechanism for replenishing the resist liquid into the cartridge 12. In this case, after the arm unit 53 has placed the used cartridge 12 on the standby unit 13, the arm unit 53 is kept engaged with the cartridge 12 and the actuating mechanism 55 (housing 81) of the arm unit 53 moves the wall surface part 25 backward so as to replenish the resist liquid into the cartridge 12. Thereafter, the arm unit 53 again transports the cartridge 12 having been filled with the resist liquid to the processing unit 11. Also in such a configuration, since the liquid passages used for ejecting the resist liquid to a wafer W are shortened, a large-sized pump and/or pipes having excellent pressure resistance is no longer needed.

[Examples]

(Experiment 1)

Resist liquid was ejected onto wafers W having a diameter of 450 mm, while changing the ejection amount of the resist liquid. The spread area in which the resist liquid spreads (expands) on the surface of each wafer W was observed. In detail, after an amount of the resist liquid had been ejected to a central portion of the wafer W while the wafer W was rotated about the vertical axis at a rotating speed, the radius of the resist liquid (resist film) spreading in a circle on the surface of each wafer W was measured.
The result is described below. As shown in Fig. 25, when 15 grams of the resist liquid was ejected to the wafer W rotating at 600 rpm, the resist liquid spread in a circle having a radius of 150 mm. Thus, it can be understood that 15 grams of resist liquid was sufficient to coat the whole surface of a wafer W having a diameter of 300 mm with the resist liquid. It can be also understood that 30 grams of the resist liquid was required to coat the whole surface of a wafer W having a diameter of 450 mm with the resist liquid. That is, the required amount of the resist liquid for the 450-mm wafer was twice as the required amount of the resist liquid for the 300-mm wafer. Even when the rotating speed of the wafer W was increased up to 1000 rpm, 30 grams of resist liquid was still required to coat the whole surface of a wafer W having a diameter of 400 mm with the resist liquid.

(Experiment 2)

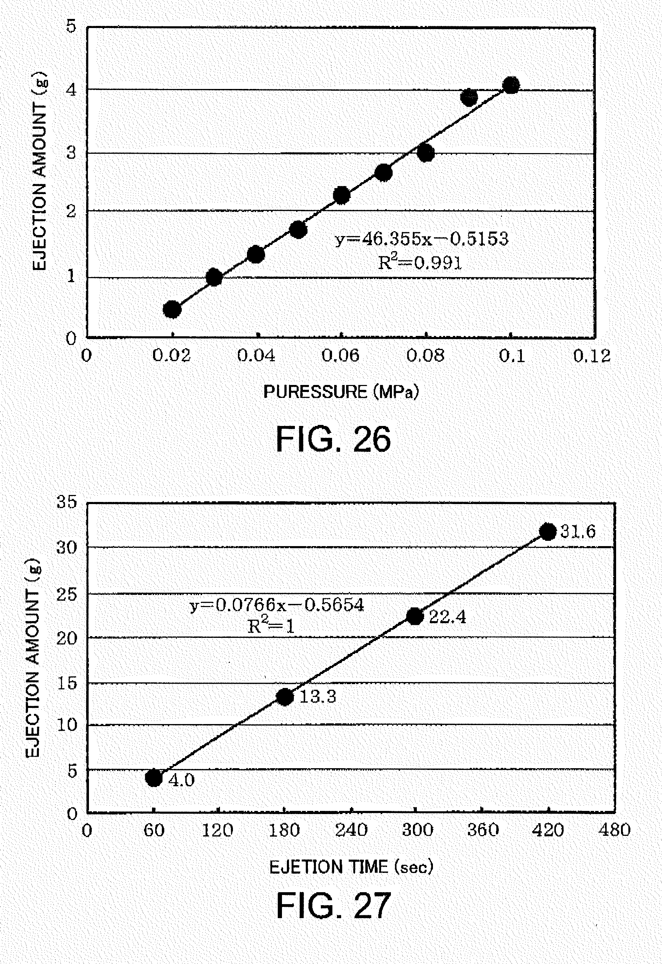

The next experiment was conducted to examine the relationship between the resist liquid discharging pressure (i.e., the pressure applied to the space 25a to eject the resist liquid from the nozzle 21) and the amount of the resist liquid ejected from the nozzle 21, in a case where the resist liquid stored in the cartridge 12 is ejected by pressurizing the cartridge 12. The result is described below. As shown in Fig. 26, it can be understood that the pressure and the ejection amount of the resist liquid were closely correlated with each other. In addition, in a case where the pressure applied to the cartridge 12 was fixed at a given value, the correlation between the ejection time during which the resist liquid was being ejected, and the ejection amount of the resist liquid was examined. Fig. 27 shows the result. It can be understood that the ejection time of the resist liquid and the ejection amount of the resist liquid were closely related to each other.

(Experiment 3)

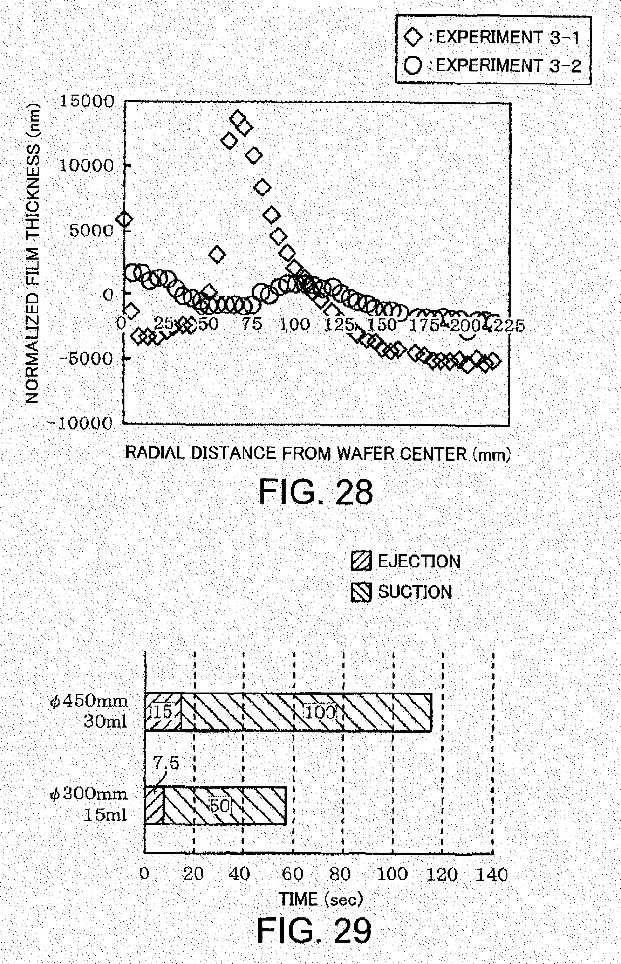

An experiment was conducted to examine how the ejection time of the resist liquid gave an impact on the quality of a resist film. When the resist liquid was ejected at a very slow ejection rate of 0.08 ml/second (the ejection time was about 400 seconds), the film thickness was non-uniform in a plane of the wafer W, as indicated by white squares (Experiment 3-1) in the graph of Fig. 28. On the other hand, when the ejection time was 20 seconds, a uniform film thickness profile was obtained, as indicated by white circles (Experiment 3-2) in the graph of Fig. 28. It can be said that if the resist liquid ejection rate is low, in other words, if the time period from the starting of the resist liquid ejection to the completion of the resist liquid ejection is long, the resist liquid ejected earlier may become dried and solidified. It can be also said that, when the resist liquid is supplied to a wafer W having a diameter of 450 mm at the same ejection speed for a wafer W having a diameter of 300 mm, there is a possibility that not only the throughput of the apparatus but also the film thickness uniformity are deteriorated.

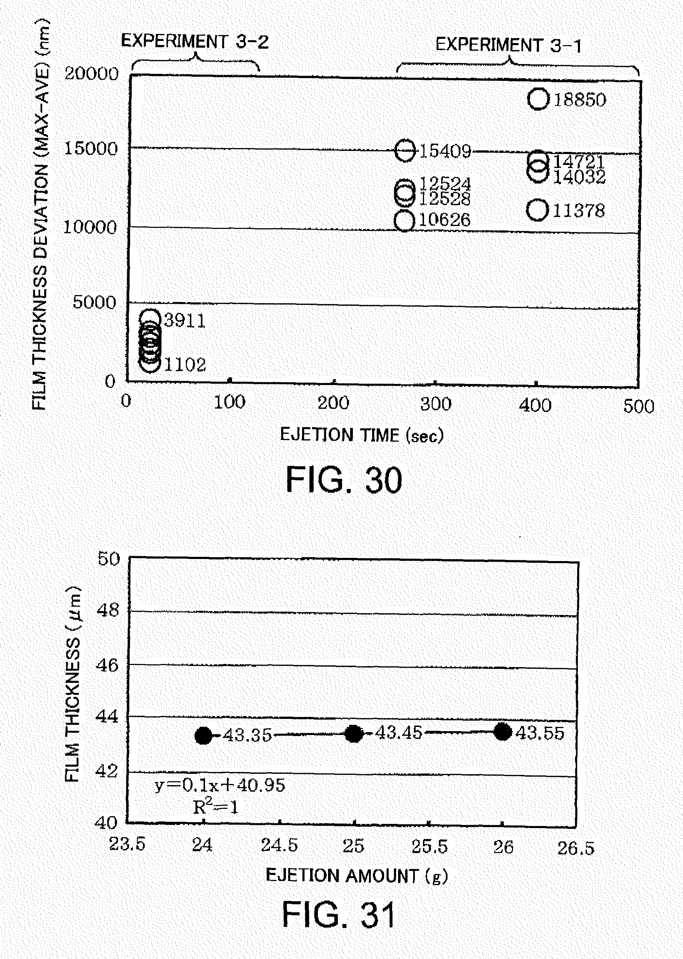

Fig. 29 schematically shows the time required for ejecting a resist liquid to a wafer having a diameter of 300 mm and of 400 mm, and the time required for replenishing the resist liquid to the cartridge. When a new resist liquid is replenished to the cartridge after ejection of the resist liquid stored in the cartridge, the resist suctioning rate (at which the resist liquid is replenished to the cartridge) cannot be set so high in order to prevent generation of bubbles in the resist liquid. Thus, as compared with the 300-mm wafer, 450-mm wafer requires not only a longer resist suction time but also resist suction time, and the total required time for 450-mm wafer is about three times as that for the 300-mm wafer. Fig. 30 shows results of the above-described "Experiment 3-1" and "Experiment 3-2", in which the resist film thickness uniformity was evaluated by an evaluation indicator which is calculated by subtracting the average film thickness from the maximum film thickness in each wafer W. "Experiment 3-1" and "Experiment 3-2" were each performed plural times, and the reproducibility of the aforementioned result "Experiment 3-1" and "Experiment 3-2" was confirmed.

(Experiment 4)

Fig. 31 shows the correlation between the ejection amount (weight) of the resist liquid and the thickness of a resist film, in a case where the rotating speed and the rotating time of the wafer W were fixed at certain values. In the graph, the horizontal axis (X axis) indicates the ejection amount, while the vertical axis (Y axis) indicates the ejection amount. The film thickness can be expressed by the following Equation (1).

$$Y=0.1X+40.95 \dots (1)$$

Thus, in the previously described embodiment employing the weight measuring unit 121, the expected film thickness Y is calculated from Equation (1).

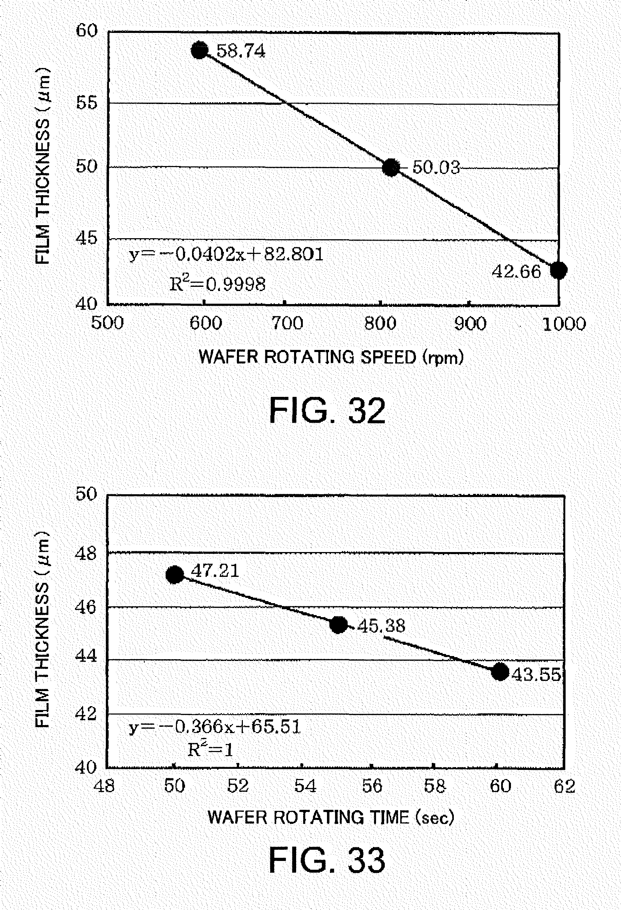

Figs. 32 and 33 each show the data that proves that the correction of the expected film thickness Y is possible in the previously described embodiment employing the weight measuring unit 121. Fig. 32 shows the correlation between the wafer rotating speed (X) and the resist film thickness (Y), which can be expressed by the following equation (2).

$$Y=-0.0402X+82.801 \dots (2)$$

Thus, it can be understood that, when it is required that the expected film thickness Y is corrected by changing the rotating speed of the wafer W, the rotating speed of the wafer W should be increased (or decreased) by a value ($\Delta$x1) obtained by dividing the correction film thickness $\Delta$Y by the value of "-0.0402".
Fig. 33 shows the correlation between a time for which the rotation of the wafer W is maintained (rotation duration or rotating time (X)) and the resist film thickness (Y), which can be expressed by the following equation (3).

$$Y=-0.366X+65.51 \dots (3)$$

When it is required that the expected film thickness Y is corrected by adjusting the rotating time, the rotating time should be increased (or decreased) by a value ($\Delta$x2) obtained by dividing the correction film thickness $\Delta$Y by a value of "-0.366". By using the rotating time as an adjusting parameter of the expected film thickness Y in addition to the rotating speed of the wafer W, the adjustment range is widened due to synergy effect.

**Claims**

1. A liquid supplying apparatus for supplying a processing liquid to a process object, comprising:

   a processing liquid cartridge including: a reservoir chamber for storing the processing liquid; an ejecting port for ejecting the processing liquid stored in the reservoir chamber; a pusher unit for pushing the processing liquid stored in the reservoir chamber outward through the ejecting port; and a replenishing port for replenishing the processing liquid into the reservoir chamber;
   a standby unit having a standby area where the processing liquid cartridge is standing-by;
   a transport mechanism that transports the processing liquid cartridge between the standby unit and a location where the processing liquid cartridge supplies the processing liquid to the process object; and
   an actuating mechanism provided in the transport mechanism that drives the pusher unit to push the processing liquid stored in the reservoir chamber.

2. The liquid supplying apparatus according to claim 1, wherein the standby unit has a processing liquid replenishing passage for replenishing the processing liquid to the processing liquid cartridge,
   said liquid supplying apparatus further comprising a replenishing mechanism that replenishes the processing liquid to the reservoir chamber of the processing liquid cartridge through the replenishing port.

3. The liquid supplying apparatus according to claim 2, wherein the replenishing mechanism is provided in the standby unit.

4. The liquid supplying apparatus according to any one of the preceding claims, wherein:

   the pusher unit includes a bellows body having a proximal opened end portion, and the reservoir chamber has an opened end portion to which the proximal opened end portion of bellows body is joined; and
   the actuating mechanism is configured to expand the bellows body to reduce a volume of the reservoir chamber, thereby to eject the processing liquid from the ejecting port.

5. The liquid supplying apparatus according to claim 4, further comprising a replenishing mechanism that replenishes the processing liquid to the reservoir chamber of the processing liquid cartridge located in the standby unit through the replenishing port, wherein the replenishing mechanism is configured to compress the bellows body to increase the volume of the reservoir chamber, thereby to suction the processing liquid through the replenishing port.

6. The liquid supplying apparatus according to claim 4 or 5, wherein:

the pusher unit has a driving rod having a distal end connected to a distal end of the bellows body and a proximal end extending outward from the reservoir chamber; and
the actuating mechanism includes a forward driving unit that drives the driving rod forward to expand the bellows body.

7. The liquid supplying apparatus according to any one of claims 4 to 6, further comprising a replenishing mechanism that replenishes the processing liquid to the reservoir chamber of the processing liquid cartridge located in the standby unit through the replenishing port,
wherein the pusher unit has a driving rod having a distal end connected to a distal end of the bellows body and a proximal end extend outward from the reservoir chamber, and
the actuating mechanism includes a backward driving unit that drives the driving rod backward to compress the bellows body.

8. The liquid supplying apparatus according to claim 4 or 5, wherein the actuating mechanism includes a gas supply unit that supplies a gas into an interior of the bellows body through the opened end portion of the bellows body, thereby to expand the bellows body.

9. The liquid supplying apparatus according to any one of claims 4, 5 and 8, further comprising a replenishing mechanism that replenishes the processing liquid to the reservoir chamber of the processing liquid cartridge located in the standby unit through the replenishing port,
wherein the replenishing mechanism includes a suction mechanism that suctions the processing liquid in the bellows body through the opened end portion of the bellows body, thereby to compress the bellows body.

10. The liquid supplying apparatus according to any one of preceding claims, wherein the processing liquid cartridge has a memory in which a type of the processing liquid stored in the processing liquid cartridge is stored.

11. The liquid supplying apparatus according to claim 10, wherein the standby unit has a plurality of standby areas, and a reading unit that reads the type of the processing liquid stored in the processing liquid cartridge stored in the memory,
said liquid supplying apparatus further comprising a control unit configured to output a control signal instructing to select one from a plurality of processing liquid cartridges suitable for a coating process to be performed to a process object, based on data read out by the reading unit.

12. The liquid supplying apparatus according to any one of the preceding claims, wherein:

the processing liquid cartridge has a locking mechanism that locks the pusher unit at a position remote from the ejecting port; and
the transport mechanism is provided with a release mechanism that releases locking of the pusher unit by the locking mechanism.

13. The liquid supplying apparatus according to any one of the preceding claims, wherein:

the processing liquid cartridge includes a first back-flow prevention mechanism for preventing a backflow of the processing liquid into the reservoir chamber through the ejecting port, and a second back-flow prevention mechanism for preventing a backflow of the processing liquid from the reservoir chamber through the replenishing port; and
a drip prevention mechanism is provided between the first back-flow prevention mechanism and the ejecting port to suction the processing liquid existing near the ejecting port upward toward the reservoir chamber, after ejection of the processing liquid.

14. The liquid supplying apparatus according to any one of the preceding claims, wherein a viscosity of the processing liquid is within a range of 1000cP to 4000cP.

FIG. 1

FIG. 2

FIG. 3

FIG. 4

FIG. 5

FIG. 6

FIG. 7

FIG. 8

FIG. 9

FIG. 10

FIG. 11

FIG. 12

FIG. 13

FIG. 14

| CARTRIDGE NO. (IC CHIP NO.) | LIQUID TYPE | LIQUID AMOUNT |
|---|---|---|
| 1 | RESIST 1 | REPLENISH COMPLETED |
| 2 | RESIST 1 | IN USE |
| 3 | RESIST 1 | DURING REPLENISH |
| 4 | RESIST 2 | DURING REPLENISH |
| 5 | RESIST 2 | REMAIN 100 ml |
| 6 | RESIST 3 | REPLENISH COMPLETED |

CPU 72

73
EJECTION PROGRAM — 73a
LIQUID REPLENISHING PROGRAM — 73b
CARTRIDGE SELECTING PROGRAM — 73c
AUTHENTICITY JUDGING PROGRAM — 73d
71

INPUT UNIT 74

75

DISPLAY UNIT 76

IC CHIP READING UNIT 44

EP 2 884 528 A1

FIG. 15

FIG. 16

FIG. 17

FIG. 18

FIG. 19

FIG. 20

FIG. 21

FIG. 22

START

REGISTER RECIPE — S1

INPUT MINIMUM RESIST EJECTION AMOUNT Amin — S2

START WAFER TRANSPORT — S3

S4 — MEASURE CARTRIDGE WEIGHT

S5 — EJECT RESIST LIQUID

S6 — MEASURE CARTRIDGE WEIGHT

S7 — CALCULATE RESIST EJECTION AMOUNT

S8 — $A \geq Amin$ ? — N

Y

CALCULATE DIFFERENCE BETWEEN TARGET FILM THICKNESS Y' AND EXPECTED FILM THICKNESS Y — S9

SET CORRECTION FILM THICKNESS $\Delta Y$ — S10

CREATE CORRECTION RECIPE — S11

UPDATE RECIPE — S12

START COATING PROCESS — S13

REPLENISH RESIST LIQUID TO CARTRIDGE — S14

END

FIG. 23

FIG. 24

FIG. 25

FIG. 26

FIG. 27

FIG. 28

FIG. 29

FIG. 30

FIG. 31

FIG. 32

FIG. 33

Europäisches
Patentamt

European
Patent Office

Office européen
des brevets

# EUROPEAN SEARCH REPORT

Application Number

EP 14 19 7625

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | WO 2004/075264 A2 (ASML HOLDING NV [NL]; BEM BRANKO [US]; BABIKIAN DIKRAN [US]) 2 September 2004 (2004-09-02) | 1,2,6,7, 14 | INV. H01L21/67 |
| Y | * paragraph [0021] - paragraph [0030] * * figures 4-7 * | 4,5, 10-13 | |
| A | | 3,8,9 | |
| X | EP 2 095 879 A1 (ABB KK [JP]) 2 September 2009 (2009-09-02) | 1,3,8,9 | |
| A | * paragraph [0015] - paragraph [0061] * * figures 1-7 * | 2,4-7, 10-14 | |
| Y | JP H11 20185 A (SEIKO EPSON CORP) 26 January 1999 (1999-01-26) | 4,5 | |
| A | * paragraph [0020] - paragraph [0025] * * figure 1 * | 1 | |
| Y | WO 82/00457 A1 (PROD RES & CHEM CORP [US]) 18 February 1982 (1982-02-18) | 10,11 | |
| A | * page 2, paragraph 4 - page 3, paragraph 3 * * figure 1 * | 1 | |
| | | | TECHNICAL FIELDS SEARCHED (IPC) |
| Y | WO 2009/047501 A1 (VIDEOJET TECHNOLOGIES INC [US]; ZABA JERZY [GB]; FOST IAN [GB]) 16 April 2009 (2009-04-16) | 12 | H01L |
| A | * page 7, line 28 - page 8, line 9 * * figure 4 * | 1 | |
| Y | EP 0 851 302 A1 (TOKYO ELECTRON LTD [JP]; TOSHIBA KK [JP]) 1 July 1998 (1998-07-01) | 13 | |
| A | * column 10, line 25 - line 39 * * pages 7A,7B * | 1 | |
| Y | WO 2013/027695 A1 (CKD CORP [JP]; SUGATA KAZUHIRO [JP]; NAKAGAKI TAKEHITO [JP]; MIYASHITA) 28 February 2013 (2013-02-28) | 13 | |
| A | * paragraph [0039] - paragraph [0041] * * figures 2,3 * | 1 | |

The present search report has been drawn up for all claims

| Place of search | Date of completion of the search | Examiner |
|---|---|---|
| The Hague | 3 February 2015 | Meixner, Matthias |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

 

& : member of the same patent family, corresponding document

EPO FORM 1503 03.82 (P04C01)

**ANNEX TO THE EUROPEAN SEARCH REPORT
ON EUROPEAN PATENT APPLICATION NO.** EP 14 19 7625

This annex lists the patent family members relating to the patent documents cited in the above-mentioned European search report.
The members are as contained in the European Patent Office EDP file on
The European Patent Office is in no way liable for these particulars which are merely given for the purpose of information.

03-02-2015

| Patent document cited in search report | | Publication date | Patent family member(s) | | | Publication date |
|---|---|---|---|---|---|---|
| WO 2004075264 | A2 | 02-09-2004 | CN | 1754247 | A | 29-03-2006 |
| | | | JP | 4227171 | B2 | 18-02-2009 |
| | | | JP | 2006518931 | A | 17-08-2006 |
| | | | KR | 20050115864 | A | 08-12-2005 |
| | | | US | 2004248425 | A1 | 09-12-2004 |
| | | | US | 2006127822 | A1 | 15-06-2006 |
| | | | WO | 2004075264 | A2 | 02-09-2004 |
| EP 2095879 | A1 | 02-09-2009 | CN | 101541436 | A | 23-09-2009 |
| | | | EP | 2095879 | A1 | 02-09-2009 |
| | | | JP | 4976417 | B2 | 18-07-2012 |
| | | | KR | 20090046854 | A | 11-05-2009 |
| | | | US | 2010243101 | A1 | 30-09-2010 |
| | | | WO | 2008065794 | A1 | 05-06-2008 |
| JP H1120185 | A | 26-01-1999 | JP | 3489399 | B2 | 19-01-2004 |
| | | | JP | H1120185 | A | 26-01-1999 |
| WO 8200457 | A1 | 18-02-1982 | EP | 0056812 | A1 | 04-08-1982 |
| | | | US | 4371094 | A | 01-02-1983 |
| | | | WO | 8200457 | A1 | 18-02-1982 |
| WO 2009047501 | A1 | 16-04-2009 | CN | 101896354 | A | 24-11-2010 |
| | | | CN | 103057274 | A | 24-04-2013 |
| | | | CN | 201432474 | Y | 31-03-2010 |
| | | | DE | 202008018274 | U1 | 04-07-2012 |
| | | | EP | 2195169 | A1 | 16-06-2010 |
| | | | EP | 2535192 | A2 | 19-12-2012 |
| | | | KR | 20100088608 | A | 09-08-2010 |
| | | | US | 2010208013 | A1 | 19-08-2010 |
| | | | US | 2013120510 | A1 | 16-05-2013 |
| | | | WO | 2009047501 | A1 | 16-04-2009 |
| EP 0851302 | A1 | 01-07-1998 | DE | 69702291 | D1 | 20-07-2000 |
| | | | DE | 69702291 | T2 | 08-02-2001 |
| | | | EP | 0851302 | A1 | 01-07-1998 |
| | | | JP | 3333121 | B2 | 07-10-2002 |
| | | | JP | H10242045 | A | 11-09-1998 |
| | | | KR | 100375037 | B1 | 09-05-2003 |
| | | | SG | 75820 | A1 | 24-10-2000 |
| | | | TW | 414962 | B | 11-12-2000 |
| | | | US | 6059880 | A | 09-05-2000 |
| WO 2013027695 | A1 | 28-02-2013 | JP | 5596639 | B2 | 24-09-2014 |
| | | | JP | 2013044372 | A | 04-03-2013 |
| | | | KR | 20140050109 | A | 28-04-2014 |

EPO FORM P0459

For more details about this annex : see Official Journal of the European Patent Office, No. 12/82

**ANNEX TO THE EUROPEAN SEARCH REPORT
ON EUROPEAN PATENT APPLICATION NO.**

EP 14 19 7625

This annex lists the patent family members relating to the patent documents cited in the above-mentioned European search report.
The members are as contained in the European Patent Office EDP file on
The European Patent Office is in no way liable for these particulars which are merely given for the purpose of information.

03-02-2015

| Patent document cited in search report | Publication date | Patent family member(s) | Publication date |
|---|---|---|---|
| | | US 2014158230 A1 | 12-06-2014 |
| | | WO 2013027695 A1 | 28-02-2013 |

EPO FORM P0459

For more details about this annex : see Official Journal of the European Patent Office, No. 12/82

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 4227171 B
- JP 2004172201 A